# FASCICULE DE BREVET EUROPEEN

(11) **EP 4 639 771 B1**
(45) Date de publication et mention de la délivrance du brevet: **11.11.2026**
(21) Numéro de dépôt: 23836545.6
(22) Date de dépôt: 05.12.2023
(51) Int. Cl.: H03K 25/02, H04N 25/772

(54) **COMPTEUR ANALOGIQUE SYNCHRONE PRECIS**
PRÄZISES SYNCHRONES ANALOGZÄHLER
PRECISE SYNCHRONOUS ANALOG COUNTER

(30) Priorité: 23.12.2022 FR 2214377
(43) Date de publication de la demande: 29.10.2025
(73) Titulaire: LYNRED, 91120 Palaiseau (FR)
(72) Inventeur: SANSON, Eric, 38113 Veurey Voroize (FR)
(74) Mandataire: Ipsilon
(86) Numéro de dépôt international: PCT/FR2023/051921
(87) Numéro de publication internationale: WO 2024/134054

(56) Documents cités:
- US-A1- 2010 213 353
- BERKOVICH ANDREW ET AL: "A low-light SPAD vision array", 2014 IEEE INTERNATIONAL SYMPOSIUM ON CIRCUITS AND SYSTEMS (ISCAS), IEEE, 1 June 2014 (2014-06-01), pages 1861 - 1864, XP032624640, DOI: 10.1109/ISCAS.2014.6865521
- LU JIYUAN ET AL: "A Compact SPAD Pixel With Active Quenching And Recharging", 2019 CHINA SEMICONDUCTOR TECHNOLOGY INTERNATIONAL CONFERENCE (CSTIC), IEEE, 18 March 2019 (2019-03-18), pages 1 - 3, XP033573712, DOI: 10.1109/CSTIC.2019.8755764

## Description

### DOMAINE TECHNIQUE

L'invention concerne un compteur permettant de compter un nombre d'événements détectés sur un signal d'entrée logique, c'est-à-dire un signal d'entrée pouvant prendre deux états de tension. L'invention vise un compteur « analogique » car la sortie est fournie sous la forme d'un signal analogique, de sorte que chaque niveau de tension du signal analogique de sortie représente un nombre de sortie du compteur.

L'invention concerne plus spécifiquement un compteur analogique « synchrone », c'est-à-dire un compteur analogique dont la détection des évènements sur le signal d'entrée logique est synchronisée avec une horloge.

L'invention vise plus particulièrement à obtenir un compteur analogique synchrone de grande précision, dans le sens qu'il ne dépend pas au premier ordre des paramètres technologiques de la technologie utilisée, tels que la dispersion des tensions de seuil des transistors, ou de la valeur des capacités.

Ainsi, l'invention peut trouver une application dans un grand nombre de domaines techniques pour lesquels il est recherché d'effectuer un comptage avec une surface limitée d'implantation du circuit remplissant cette fonction de comptage, et par exemple pour les photodiodes à avalanche mono-photonique, également appelées SPAD pour « Single-Photon Avalanche Diode » dans la littérature anglo-saxonne, les convertisseurs analogique-numérique, ou les réseaux de neurones.

### ETAT DE LA TECHNIQUE

Pour obtenir une implantation d'un circuit électronique avec une surface limitée, il est connu d'utiliser la technologie CMOS, pour « Complementary metal-oxide-semiconductor » dans la littérature anglo-saxonne.

Dans cette technologie CMOS, un compteur logique est généralement réalisé par des fonctions logiques, par exemple des bascules logiques de type D. Pour un compteur logique de N bits, N bascules sont classiquement nécessaires pour implémenter un compteur logique pouvant compter jusqu'à 2^{N}. En outre, une mémorisation du comptage est également nécessaire, par exemple au moyen d'un registre intégrant également N bascules. La surface de silicium nécessaire pour réaliser un compteur logique est donc proportionnelle au nombre de bascules nécessaires, et cette surface est incompressible.

Dans certains cas précis, la surface de silicium est limitée, par exemple si le compteur doit être implanté dans un pixel au sein d'une matrice de dimension définie. Si cette surface n'est pas suffisante pour implémenter un compteur logique avec la précision attendue, il est possible de rechercher à implémenter un compteur analogique.

En effet, les fonctions logiques stockent l'information sur deux niveaux logiques, 0 et 1. Une autre solution possible est de stocker l'information sous forme d'une tension analogique à M niveaux possibles. Ainsi, avec une capacité pouvant stocker M quantités de charges distinctes, et donc présenter M niveaux de tension distincts à ses bornes, il est possible de remplacer N bascules classiquement utilisées pour obtenir un compteur avec une sortie logique permettant le comptage jusqu'à 2^{N}. Pour ce faire, il convient de sélectionner le nombre de charges à compter M pouvant être stockées dans la capacité de sorte que ce nombre de charges M soit inférieur ou égal au nombre 2^{N}.

Une seconde capacité peut également mémoriser le résultat du comptage en transférant les charges de la première à la seconde capacité, de sorte à remplacer les N autres bascules du registre. Avec un compteur analogique, il est donc possible de limiter la surface d'implantation.

Un compteur logique a donc une dynamique de comptage limitée à 2^{N}. Un compteur analogique a une dynamique de comptage limitée par sa précision qui lui permet de distinguer M niveaux de tension différents en sortie. Par analogie, il est courant de parler d'un compteur analogique de N bits lorsque sa précision permet de remplir la fonction des compteurs logiques ayant un nombre de bits inférieurs ou égal à N.

Un compteur analogique intègre classiquement un circuit électronique de comptage et un circuit de génération des signaux de commande du compteur. Le circuit électronique permet de convertir le nombre d'événements détectés pendant une période de comptage en tension équivalente, avec une précision suffisante pour les M niveaux distincts.

Les évènements peuvent correspondre à des fronts montants ou descendants d'un signal logique d'entrée. En outre, les évènements peuvent correspondre à une variation de l'état logique d'un signal d'entrée. Par exemple, en utilisant un signal logique d'entrée normalement à l'état haut, il est possible de détecter les évènements pour lesquels le signal logique d'entrée est placé à l'état bas. Pour ce faire, il est possible de mettre en œuvre des cycles de détection dans la période de comptage, et de vérifier l'état logique du signal logique d'entrée à chaque cycle de détection. Ainsi, le compteur logique est incrémenté à chaque cycle de détection pour lequel un évènement du signal logique d'entrée est détecté, par exemple un état bas sur le signal logique d'entrée.

Dans le cas d'un compteur analogique, l'incrémentation du compteur logique se traduit par une augmentation ou une diminution de la tension de sortie.

Pour ce faire, des compteurs analogiques utilisent un transfert de charges dans une capacité d'intégration aux bornes de laquelle la tension de sortie est mesurée.

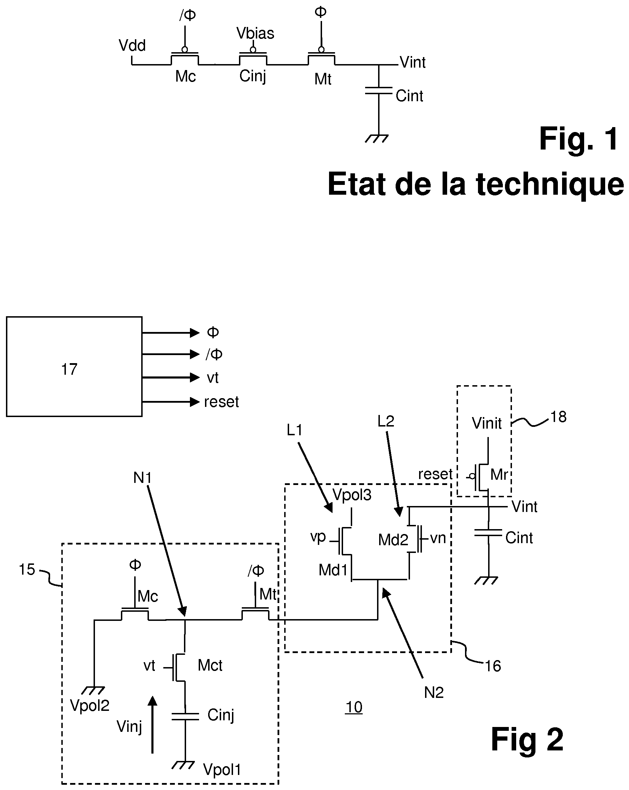

Par exemple, dans la publication scientifique « An analog counter architecture for pixel-level ADC », Peizerat, Arnaud et al. (2009), un circuit électronique illustré sur la figure 1 de l'état de la technique propose d'utiliser une capacité CMOS **Cinj** pour injecter périodiquement des charges dans une capacité d'intégration **Cint.**

La tension de sortie **Vint** est mesurée aux bornes de cette capacité d'intégration **Cint.** La capacité CMOS **Cinj** est réalisée au moyen d'un transistor PMOS, dont la tension de grille est fixée à une tension **Vbias.** La source de ce transistor **Cinj** est connectée au drain d'un transistor de charge **Mc** alors que le drain de ce transistor **Cinj** est connecté à la source d'un transistor de transfert **Mt.** Le transistor de charge **Mc** est également connecté par sa source à une tension de polarisation **Vdd** alors que le drain du transistor de transfert **Mt** est connecté à la tension de sortie **Vint.**

La grille des deux transistors **Mc, Mt** est commandée par des signaux d'horloge **Φ**, /**Φ** en opposition de phase de sorte à charger la capacité CMOS **Cinj** lorsque le transistor de charge **Mc** est passant et le transistor de transfert **Mt** bloqué ; et à transférer les charges de la capacité CMOS **Cinj** vers la capacité d'intégration **Cint** lorsque le transistor de charge **Mc** est bloqué et le transistor de transfert **Mt** passant.

Ce circuit électronique de la figure 1 réalise ainsi un transfert de charges depuis la capacité CMOS **Cinj** vers la capacité d'intégration **Cint** à chaque cycle des signaux d'horloge **Φ**, /**Φ**. Plus précisément, à chaque cycle, les charges transférées passent par un transistor de transfert **Mt** et elles correspondent, au premier ordre, à **Vdd-Vbias-Vt, Vt** correspondant à la tension de seuil du transistor PMOS réalisant la capacité CMOS **Cint.**

Or, ce transistor PMOS intègre inévitablement une dispersion de sa tension de seuil **Vt.** D'autre schémas de transfert de charges existent dans l'état de l'art mais ils sont également affectés par les dispersions de **Vt** des transistors de charge ou de transfert.

Cette dispersion de la tension de seuil **Vt** est principalement inhérente au procédé de fabrication. Elle peut être évaluée par des simulations de type Monte-Carlo. Plus précisément, cette dispersion est fonction de l'usine de fabrication, du lot de fabrication, de la tranche fabriquée, de la puce sur la tranche... Il existe aussi une dispersion locale dont la valeur est inversement proportionnelle à la racine carrée de la surface du transistor. Cette dispersion peut être de plusieurs millivolts, ou de plusieurs dizaines de millivolts et entraine une variation de comportement d'un compteur par rapport à un autre compteur voisin, par exemple lorsque plusieurs compteurs sont associés à plusieurs pixels.

En raison de la dispersion de la tension de seuil **Vt,** chaque compteur analogique d'une matrice possède sa propre courbe de transfert décrivant l'évolution de la tension de sortie en fonction de chaque évènement détecté.

Si cette courbe de transfert est différente d'un compteur à l'autre, il est nécessaire de réduire la dynamique de comptage pour tolérer la marge d'erreur entre les différentes courbes, ou mesurer chacune des courbes pour corriger leurs erreurs pour augmenter la précision.

Dans la pratique, il est très difficile de faire une correction personnalisée pour chaque pixel, et la réduction de la dynamique de comptage est classiquement utilisée, c'est pourquoi il est difficile de réaliser un compteur analogique de plus de 3 bits.

La dynamique d'un compteur analogique résulte de la précision de chaque incrément de tension pour passer d'un niveau au niveau suivant au cours du comptage, mais aussi de la précision de l'incrément d'un compteur par rapport à l'incrément de chacun des autres compteurs présents dans chaque pixel d'une matrice.

L'état de l'art des compteurs analogiques existant permet de réaliser des compteurs de 3 bits. Certains revendiquent 4 bits de comptage avec des architectures particulièrement complexes.

A titre d'exemple, pour réaliser un compteur de 4 bits, donc 16 niveaux distincts (15 incréments) sur une dynamique de tension de 3V, il faut des incréments de tension de 0,2V. Pour identifier les niveaux de la sortie, la tension de sortie est reconnue comme représentative du niveau qui lui est le plus proche, le seuil séparant deux niveaux successifs est donc situé au milieu des deux niveaux, soit à 0,1V du niveau idéal. L'écart statistique de la sortie par rapport au niveau idéal, répond à une loi normale. Pour éviter les erreurs de détection de niveau sur l'ensemble des compteurs d'une matrice ayant par exemple un million de pixels, il faut situer le seuil séparant les niveaux à au moins cinq fois l'écart-type du niveau idéal. L'écart-type de l'écart statistique doit donc être de l'ordre de 20 mV. La source dominante de l'erreur statistique en sortie est l'erreur statistique de l'incrément. En effet, cette erreur de l'incrément se répète lors du comptage, et se cumule en sortie, L'erreur statistique en sortie et alors égale à M fois l'erreur statistique de l'incrément, M étant la dynamique du compteur. Dans le cas d'un compteur 4 bit, l'écart-type de l'erreur sur l'incrément doit être 15 fois plus petite que l'écart-type de l'erreur en sortie, soit un écart type de l'erreur sur l'incrément de 1,3 mV. Cet exemple illustre la difficulté de réalisation d'un compteur analogique 4 bits avec la dispersion des tensions de seuil **Vt** des transistors réalisés en technologie CMOS : de quelque mV à quelques dizaines de mV.

Il est à noter que pour augmenter d'un bit la dynamique d'un compteur analogique, il faut améliorer la précision de l'incrément d'un facteur 4.

Cette problématique de la dispersion de la tension de seuil **Vt** d'un transistor lié au transfert de charges et nécessitant de réduire la précision est commune à un grand nombre de compteurs logiques à sortie analogique connus, notamment ceux décrits dans les documents US 2021/0226637, WO 2021/150296, US 10,931,296 et US 10,594,299. Ce dernier document US 10,594,299 décrit clairement cette problématique de limitation de la précision, et il propose d'augmenter cette précision en mettant en œuvre plusieurs compteurs logiques à sortie analogique en cascade. Cependant, cette solution nécessite de gérer les retenues entre les compteurs en cascade et les signaux de reset au cours du comptage. En outre, la multiplicité des compteurs logiques à sortie analogique augmente la surface d'implantation.

Certains compteurs logiques à sortie analogique intègrent également des amplificateurs, tel que décrit dans un mode de réalisation de la publication scientifique « A 64 × 64 SPAD-Based Indirect Time-of-Flight Image Sensor With 2-Tap Analog Pulse Counters » Byungchoul Park et al. IEEE JOURNAL OF SOLID-STATE CIRCUITS (2021).

L'utilisation de ce type de composant pose des problèmes de consommation. En effet, la consommation d'un amplificateur est de l'ordre de 600nA lorsqu'un circuit qui utilise uniquement des composants discrets, tels que des transistors, consomme dix fois moins de courant.

Le document US 2010213353 A décrit un compteur analogique similaire.

Le problème technique de l'invention est donc d'obtenir un compteur analogique avec une précision plus importante que les compteurs de ce type connus, permettant une implantation sur une surface limitée, et présentant une consommation électrique limitée.

### EXPOSE DE L'INVENTION

Pour répondre à ce problème technique, l'invention propose de mettre en œuvre un circuit de génération périodique de charges calibrées et un circuit d'aiguillage des charges commandé par un signal logique d'entrée.

Ces circuits permettent de générer périodiquement des charges précises au cours d'un cycle de détection, et à aiguiller les charges dans une capacité d'intégration, aux bornes de laquelle la tension de sortie, uniquement lorsqu'un évènement est détecté dans le cycle de détection sur le signal logique d'entrée.

On entend par charge calibrée, une charge qui ne dépend pas, au premier ordre, des paramètres technologiques de la technologie CMOS. On choisira donc préférentiellement d'utiliser un même type de capacité pour la capacité d'injection et la capacité d'intégration de sorte que les dispersions de ce type de capacité se compensent, et que l'incrément de tension sur la capacité d'intégration ne soit pas affecté par les dispersions des capacités entre les différents lots, tranches, ou puces fabriquées.

Plus précisément, l'invention propose un circuit de génération périodique de charges calibrées mettant en œuvre un seul transistor de contrôle d'injection connecté en série avec une capacité d'injection, de sorte à utiliser ce transistor de contrôle d'injection pour charger et décharger la capacité d'injection. Pour ce faire, une phase d'initialisation, une phase de précharge et une phase de charge sont mises en œuvre dans chaque cycle de détection. Lors des phases de précharge et de charge, la tension de grille du transistor de contrôle d'injection est ajustée différemment de sorte à appliquer deux tensions successives distinctes à la capacité d'injection et, ainsi, annuler la tension de seuil du transistor de contrôle d'injection par la différence entre les deux tensions appliquées successivement à la capacité d'injection.

Il s'ensuit que des charges précisément calibrées sont générées périodiquement à l'identique et transmises au circuit d'aiguillage qui a pour rôle de sélectionner celles qui seront prises en compte pour le comptage de chaque évènement. Il devient ainsi possible d'améliorer la précision du compteur de l'invention car l'incrément du signal de sortie entre deux niveaux consécutifs de comptage peut être bien inférieurs à celui de l'état de la technique.

Par exemple, l'invention permet de mettre en œuvre un incrément du signal de sortie de l'ordre de 0,015 à 0,025 Volt entre deux niveaux de tension, permettant d'obtenir un comptage d'une précision pouvant aller jusqu'à 7 ou 8 bits.

A cet effet, l'invention concerne un compteur analogique du nombre d'évènements d'au moins un signal logique d'entrée au cours d'une période de comptage, ladite période de comptage comportant un ensemble de cycles de détection dans lesquels un évènement du signal logique d'entrée peut être détecté.

L'invention se caractérise en ce que le compteur analogique comprend :
- un circuit de génération périodique d'une quantité calibrée de charges à chaque cycle de détection ;
- une capacité d'intégration configurée pour stocker ladite quantité calibrée de charges à chaque cycle de détection de la période de comptage pour lequel un évènement du signal logique d'entrée est détecté de sorte qu'une tension de sortie, aux bornes de la capacité d'intégration, est représentative du nombre d'évènements du signal logique d'entrée détectés au cours de la période de comptage ;
- un circuit d'aiguillage de la quantité calibrée de charges commandé par le signal logique d'entrée pour stocker ladite quantité calibrée de charges dans la capacité d'intégration uniquement lorsqu'un évènement est détecté sur le signal logique d'entrée ;
- un circuit de génération de signaux de commande du compteur analogique ; et
- un circuit de réinitialisation de la tension de sortie aux bornes de la capacité d'intégration de sorte à réinitialiser le comptage.

Le circuit de génération périodique de charges calibrées comprend :
- une capacité d'injection configurée pour stocker la quantité calibrée de charges à chaque cycle de détection et connectée à l'une de ses bornes à une première tension de polarisation ;
- un transistor de contrôle d'injection dont la source est connectée à l'autre borne de la capacité d'injection, dont la grille est connectée à une tension de commande, et dont le drain est connecté à un nœud d'injection ;
- un transistor de charge dont la source est connectée à une seconde tension de polarisation et dont le drain est connecté au nœud d'injection ; et
- un transistor de transfert dont la source est connectée au nœud d'injection et dont le drain est connecté à un nœud d'aiguillage ;
la grille des deux transistors de charge et de transfert étant commandée par des signaux d'horloge en opposition de phase de sorte à charger ladite capacité d'injection puis à transférer les charges accumulées dans ladite capacité d'injection au circuit d'aiguillage.

Le circuit de génération de signaux de commande est configuré pour commander la tension de commande et les signaux d'horloge de sorte à générer successivement les phases suivantes à chaque cycle de détection :
- une phase d'initialisation au cours de laquelle le transistor de contrôle d'injection et le transistor de charge sont passants alors que le transistor de transfert est bloqué ;
- une phase de précharge au cours de laquelle le transistor de contrôle d'injection et le transistor de transfert sont passants alors que le transistor de charge est bloqué, la tension de commande étant fixée à une première valeur ; et
- une phase de charge au cours de laquelle le transistor de contrôle d'injection et le transistor de transfert sont passants alors que le transistor de charge est bloqué, la tension de commande étant fixée à une seconde valeur.

L'invention propose ainsi de générer périodiquement une quantité calibrée de charges afin que ces charges puissent être transférées dans la capacité d'intégration en fonction de l'aiguillage commandé par ledit au moins un signal logique d'entrée.

Au sens de l'invention, les charges « calibrées » correspondent à des quantités de charges qui sont plus précises que celles de l'état de la technique. En effet, en utilisant le même transistor de contrôle d'injection pour générer les deux phases de précharge et de charge avec des tensions de commande distinctes, la tension appliquée aux bornes de la capacité d'intégration à l'issue de ces deux phases est indépendante de la tension de seuil de ce transistor de contrôle d'injection.

La quantité de charges dans la capacité d'intégration dépendant de la valeur de capacité et de la différence de tension aux bornes de la capacité d'intégration, il s'ensuit que la quantité de charges qui est transférée depuis la capacité d'injection à la capacité d'intégration est plus précise car elle est indépendante, au premier ordre, des variations de cette tension de seuil.

Numériquement, avec une première valeur de tension de commande **vtx1,** une seconde valeur de tension de commande **vtx2** et une tension de seuil du transistor de contrôle d'injection **vtMct,** la tension appliquée sur une borne de la capacité d'intégration correspond à la différence **vtx1-vtMct** dans la phase de précharge et à la différence **vtx2-vtMct** dans la phase de charge. Lors de la transition entre ces deux phases, la quantité de charges dans la capacité d'intégration est donc (**vtx2-vtx1**)**.Cinj,** avec **Cinj** la valeur de la capacité d'injection. Ainsi, la quantité de charges transférée depuis la capacité d'injection à la capacité d'intégration lors de la transition entre ces deux phases est indépendante de la tension de seuil du transistor de contrôle d'injection **vtMct.**

Ce principe de fonctionnement n'est pas remis en cause si la tension de seuil du transistor de contrôle d'injection **vtMct** évolue légèrement, par effet bulk, avec la polarisation de la source du transistor de contrôle d'injection, car l'effet bulk ne dépend pas de la dispersion de la tension de seuil du transistor de contrôle d'injection **vtMct.**

Cet avantage est très important puisqu'il permet de mettre en œuvre des seuils du signal de sortie à des tensions de l'ordre de 0,015 à 0,025 Volt entre deux niveaux de tension, permettant d'obtenir un comptage dont la précision peut atteindre 7 à 8 bits.

Au sens de l'invention, les phases de « charge » ou de « précharge » correspondent à des phases à l'issue desquelles des charges en quantité précise sont générées par le circuit de génération périodique de charges calibrées et stockées dans la capacité d'injection. Ces charges calibrées peuvent être obtenues par des étapes de charge ou de décharge de la capacité d'injection sans changer l'invention.

Ces charges sont générées « périodiquement » car, à chaque cycle de détection mettant en œuvre la phase d'initialisation, la phase de précharge et la phase de charge, une quantité calibrée de charges est générée par le circuit de génération périodique de charges calibrées et stockées dans la capacité d'injection. Lors de chacun de ces cycles de détection répétés en boucle pendant toute la période de comptage, cette quantité calibrée de charges peut être transférée ou non dans la capacité d'intégration. Ce transfert est commandé par la détection d'un évènement sur au moins un signal logique d'entrée.

Les évènements peuvent correspondre à des fronts montants ou descendants d'un signal logique d'entrée. De préférence, les évènements correspondent à une variation de l'état logique d'un signal d'entrée. Par exemple, en utilisant un signal logique d'entrée dont l'état stable est l'état haut, il est possible de détecter les évènements pour lesquels le signal logique d'entrée est placé à l'état bas. Pour ce faire, il est possible de vérifier l'état logique du signal logique d'entrée à chaque cycle de détection. Ainsi, le compteur analogique est incrémenté ou décrémenté à chaque cycle de détection pour lequel un évènement du signal logique d'entrée est détecté, par exemple un état bas sur le signal logique d'entrée.

Dans le cadre de l'invention, l'incrémentation du compteur analogique se traduit par une augmentation ou une diminution de la tension de sortie aux bornes de la capacité d'intégration obtenue par un transfert de charges calibrées depuis la capacité d'injection.

Pour ce faire, le circuit d'aiguillage peut prendre plusieurs formes distinctes avec un ou plusieurs transistors fonctionnant en régime de commutation pour transférer les charges précisément calibrées qui sont validées par un évènement sur l'entrée logique, vers la capacité d'intégration, et pour évacuer toutes les autres charges vers une tension de polarisation.

De préférence, le circuit d'aiguillage comprend deux lignes :
- une ligne d'évacuation des charges comprenant un transistor d'évacuation dont la source est connectée sur ledit nœud d'aiguillage et le drain est connecté à une troisième tension de polarisation ; et
- une ligne de transfert des charges comprenant un transistor de comptage dont la source est connectée sur ledit nœud d'aiguillage et le drain est connecté à la capacité d'intégration ;
la grille des transistors des deux lignes étant commandée par des signaux logiques d'entrée qui définissent si les charges stockées dans la capacité d'injection sont évacuées ou transférées dans la capacité d'intégration.

Préférentiellement, le régime passant des deux transistors ne se fera pas en régime ohmique, mais en régime saturé pour assurer une fonction cascode lors du transfert des charges, et ainsi améliorer la linéarité.

Avec ce circuit d'aiguillage, le transistor d'évacuation de la ligne d'évacuation des charges peut être préférentiellement commandé par un signal logique d'entrée variable alors que le transistor de comptage de la ligne de transfert des charges est commandé par un signal fixe, les couplages de charges parasites entre la grille du transistor de comptage et la capacité d'intégration sont alors supprimés.

Ainsi, il est possible de faire en sorte qu'un évènement du signal logique d'entrée variable dans la phase de charge entraine un transfert des charges calibrées dans la capacité d'intégration. En variante, les signaux logiques des grilles des transistors des deux lignes peuvent être variables et correspondre à deux signaux logiques d'entrée afin de détecter des évènements sur ces deux signaux logiques d'entrée.

Typiquement, le signal logique d'entrée appliqué sur la grille du transistor de comptage peut être fixe, par exemple à une tension de 2.4 Volts. La tension appliquée sur la grille du transistor d'évacuation peut alors être fixée à 2.7 Volts et passer à 2.1 Volts lors d'un évènement. Ainsi, la tension appliquée sur la grille du transistor d'évacuation est normalement plus importante que la tension appliquée sur la grille du transistor de comptage, et les charges calibrées sont normalement évacuées vers la troisième tension de polarisation. Lors d'un évènement, la tension appliquée sur la grille du transistor d'évacuation est inférieure à la tension appliquée sur la grille du transistor de comptage et les charges calibrées sont transférées dans la capacité d'intégration.

Pour détecter des évènements pouvant apparaitre sur le signal logique d'entrée appliqué sur la grille du transistor de comptage, celui-ci peut également évoluer entre la tension de 2.4 Volts et la tension de 3 Volts.

Ainsi, un évènement du signal logique d'entrée détecté par la grille du transistor de comptage entraine une augmentation de la tension appliquée sur la grille du transistor de comptage et, la tension appliquée sur la grille du transistor d'évacuation étant inférieure à la tension appliquée sur la grille du transistor de comptage, les charges calibrées sont transférées dans la capacité d'intégration.

Ce mode de réalisation est particulièrement efficace pour commander facilement le comptage ou non des évènements survenus sur un signal logique d'entrée variable, ou un signal logique d'entrée équivalent complémenté.

En outre, avec ce circuit d'aiguillage et en reprenant le précédent exemple numérique, les seuils du signal de sortie peuvent correspondre à **Vstep=(vtx2-vtx1).Cinj/Cint,** avec **Cinj** la valeur de la capacité d'injection. De manière plus précise, la valeur de la tension de seuil du transistor de contrôle d'injection **vtMct** peut évoluer par effet bulk lorsque la tension source-bulk du transistor de contrôle d'injection **Mct** change. La charge précise est alors légèrement inférieure à la valeur théorique mais cela n'affecte pas la précision de la reproductibilité de la valeur car la contribution est du second ordre. Typiquement, **Vstep** peut être de 23 mVolts sur une plage d'amplitudes de 3 Volts, s'étendant de 1.4 à 4.4 Volts. Il est ainsi possible de coder 130 combinaisons sur une tension de sortie analogique, permettant de décrire un signal sur 7 bits de 128 combinaisons.

Ce circuit d'aiguillage transfère des charges calibrées vers la capacité d'intégration, mais il transfère également une petite charge parasite qui est dépendante de la différence de tension de seuil entre le transistor d'évacuation et le transistor de comptage.

En effet, les transistors s'échangeant le rôle de cascode, leur source commune connectée sur le nœud d'aiguillage est polarisée soit par le transistor d'évacuation, soit par le transistor de comptage, à une valeur de leur tension de grille moins la tension de seuil de chaque transistor. Cette différence de tension de seuil entre le transistor d'évacuation et le transistor de comptage est appliquée au nœud d'aiguillage lors de la commutation, et donc sur la capacité parasite vue par le nœud d'aiguillage. Ainsi, cette capacité parasite vue par le nœud d'aiguillage correspond à une charge parasite proportionnelle à la différence de tension de seuil entre le transistor d'évacuation et le transistor de comptage qui est transférée vers la capacité d'intégration.

Cette charge parasite dépendante des tensions de seuil entre le transistor évacuation et le transistor de comptage est une erreur de deuxième ordre car la capacité parasite du nœud d'aiguillage est très inférieure à la capacité d'injection, mais cette erreur devient dominante dans le cadre de l'invention qui a supprimé les erreurs de premier ordre.

Pour améliorer la précision du compteur analogique et réduire l'amplitude possible des seuils du signal de sortie, il peut être recherché d'annuler la différence de tension de seuil entre le transistor d'évacuation et le transistor de comptage des deux lignes du circuit d'aiguillage. Pour ce faire, il est possible d'utiliser une phase de réinitialisation du compteur pour mémoriser dans une capacité d'offset la différence de tension de seuil entre les deux transistors des deux lignes du circuit d'aiguillage. Il est ensuite possible de soustraire cette valeur d'offset stockée dans la capacité d'offset pour obtenir le signal logique d'entrée variable à partir d'un signal logique d'entrée contrôlé. Ainsi, les charges transférées dans la capacité d'intégration peuvent être indépendantes de la différence de tension de seuil entre le transistor d'évacuation et le transistor de comptage des deux lignes du circuit d'aiguillage et les seuils de tension du signal de sortie peuvent être réduits, de sorte à augmenter la précision du compteur analogique.

Dans ce mode de réalisation, la ligne d'évacuation des charges comprend également :
- une capacité d'offset connectée entre un signal logique d'entrée contrôlé et la grille du transistor d'évacuation de sorte que le signal logique d'entrée variable soit obtenu à partir du signal logique d'entrée contrôlé en appliquant un offset généré par la tension de la capacité d'offset ;
- un premier transistor d'offset monté entre le drain du transistor d'évacuation et la troisième tension de polarisation, la source du premier transistor d'offset étant connectée à la troisième tension de polarisation, son drain étant connecté au drain du transistor d'évacuation et sa grille étant commandée par un premier signal d'offset généré par le circuit de génération de signaux de commande ; et
- un second transistor d'offset monté entre le drain et la grille du transistor d'évacuation, le drain du second transistor d'offset étant connecté au drain du transistor d'évacuation, sa source étant connectée à la grille du transistor d'évacuation et sa grille étant commandée par un second signal d'offset généré par le circuit de génération de signaux de commande.

Le circuit de génération de signaux de commande est alors configuré pour commander le premier signal d'offset et le second signal d'offset de sorte à générer successivement les épisodes suivants dans une période de réinitialisation :
- un épisode de charge de la capacité d'offset dans lequel le premier transistor d'offset est passant et le second transistor d'offset est passant ;
- un épisode de décharge de la capacité d'offset dans lequel le premier transistor d'offset est bloqué et le second transistor d'offset est passant, cet épisode de décharge étant maintenu pendant un certain nombre de cycles de calibration au cours desquels les phases d'initialisation, de précharge et de charge sont mises en œuvre ; et
- un épisode d'échantillonnage de la capacité d'offset dans lequel le premier transistor d'offset est bloqué et le second transistor d'offset est bloqué ;
le signal d'entrée logique contrôlé étant fixé à une valeur de tension de réinitialisation durant les épisodes de charge, de décharge et d'échantillonnage.

Le circuit de génération de signaux de commande est également configuré pour commander le premier signal d'offset et le second signal d'offset de sorte que le premier transistor d'offset soit passant et le second transistor d'offset soit bloqué dans la période de comptage.

Pour mettre en œuvre ce mode de réalisation, le signal de commande doit donc correspondre à un signal logique d'entrée « contrôlé », c'est-à-dire un signal logique généré par le circuit de génération de signaux de commande.

Dans la période de réinitialisation, pour obtenir un chargement de la capacité d'offset avec une tension représentant la différence de tension de seuil entre le transistor d'évacuation et le transistor de comptage des deux lignes du circuit d'aiguillage, il est nécessaire de fixer le signal de logique d'entrée contrôlé à une tension prédéfinie.

Cette tension prédéfinie est appliquée sur une première borne de la capacité d'offset alors que la seconde borne de la capacité d'offset est reliée à la troisième tension de polarisation, à travers le second transistor d'offset qui est rendu passant. Le premier transistor d'offset étant initialement passant dans l'épisode de charge, la capacité d'offset est alors chargée à sa charge maximale. Le premier transistor d'offset est ensuite bloqué, le drain et la grille du transistor d'évacuation devient un nœud flottant dans l'épisode de décharge, polarisé par la capacité d'offset.

Pour calibrer la capacité d'offset à la valeur voulue, des charges calibrées doivent être générées par le circuit de génération périodique de charges calibrées en mettant en œuvre les phases d'initialisation, de précharge et de charge autrement utilisées dans l'épisode de décharge. Ainsi, en utilisant plusieurs cycles de calibration consécutifs dans l'épisode de décharge, par exemple 5 cycles, il est possible de décharger progressivement la capacité d'offset vers une valeur voulue finale qui est représentative de la différence de tension de seuil entre le transistor d'évacuation et le transistor de comptage des deux lignes du circuit d'aiguillage.

Cette valeur est atteinte de façon asymptotique car, dans un premier temps, les charges calibrées passent par le transistor d'évacuation, et déchargent la capacité d'offset, cette décharge fait baisser la tension de grille du transistor d'évacuation jusqu'à son seuil de conduction, c'est-à-dire le moment ou les charges calibrées passent entièrement par le deuxième transistor. Ce seuil de conduction sur la grille du transistor d'évacuation est représentatif de la différence de tension de seuil entre le transistor d'évacuation et le transistor de comptage.

Pour terminer cette période de réinitialisation, le deuxième transistor d'offset est bloqué pour échantillonner la valeur voulue sur la capacité d'offset. Ainsi, dans l'épisode d'échantillonnage, le premier transistor d'offset est rendu passant pour revenir aux conditions initiales. La grille du transistor d'évacuation est alors commandée avec un décalage d'offset qui aligne le seuil de conduction à la même valeur pour tous les pixels, la charge parasite du nœud d'aiguillage est alors identique pour tous les pixels, il n'y a plus de dépendance avec la différence des tensions de seuil entre le transistor d'évacuation et le transistor de comptage.

Préférentiellement, le compteur analogique de l'invention est intégré dans un pixel d'une matrice dans laquelle chaque pixel intègre un compteur analogique. Pour ce faire, chaque pixel a besoin de signaux de commande pour fonctionner correctement. Ces signaux peuvent être des signaux de polarisation, des signaux logiques classiques prenant le niveau des alimentations, des signaux logiques avec des niveaux de tension spécifiques pour le « 0 » et le « 1 », et des signaux logiques ou analogiques qui sont dépendants de l'entrée logique qui valide le comptage... Il peut également y avoir des signaux plus complexes tels que le signal d'entrée contrôlé qui doit prendre trois niveaux de tension distincts : un niveau de tension dans la période de réinitialisation et deux niveaux de tension pour valider ou non le comptage dans la période de comptage.

Dans la mesure du possible, tous ces signaux sont générés à l'extérieur de la matrice de pixels, mais le signal d'entrée logique est spécifique à chaque pixel, et il est donc généré dans le pixel, c'est par exemple la sortie d'un comparateur, ou les deux sorties complémentées d'un comparateur. Il y a donc nécessité d' avoir un circuit dans le pixel pour mettre en forme les signaux de commande à partir du signal d'entrée interne au pixel. Ce circuit doit être le plus petit possible car il est implanté dans le pixel.

Ainsi, pour optimiser la surface disponible pour le compteur analogique, il est préférable d'utiliser des signaux de commande identiques pour plusieurs compteurs analogiques afin que ces signaux de commande puissent être mutualisés et générés à l'extérieur de la surface de chaque pixel. Pour ce faire, il est possible d'améliorer la ligne d'évacuation des charges pour fixer la tension sur le signal logique d'entrée dans la période de réinitialisation par des signaux externes, générés de manière centralisée.

Dans ce mode de réalisation, la ligne d'évacuation des charges comprend également un circuit de génération du signal logique d'entrée variable; ce circuit comprenant :
- un premier transistor de génération dont une première borne, source ou drain, est connectée à un premier signal de génération, une seconde borne, source ou drain, est connectée au signal logique d'entrée contrôlé, et la grille est connectée à un signal logique d'entrée non-contrôlé ; et
- un second transistor de génération dont une première borne, source ou drain, est connectée à un second signal de génération, une seconde borne, source ou drain, est connectée au signal logique d'entrée contrôlé, et la grille est connectée à un signal complémentaire du signal logique d'entrée non-contrôlé.

Le circuit de génération de signaux de commande est configuré pour commander le premier signal de génération et le second signal de génération de sorte que :
- le premier signal de génération est à l'état bas dans la phase de charge et à l'état haut dans les phases d'initialisation et de précharge de la période de comptage ; et
- le second signal de génération est à l'état haut dans les phases d'initialisation, de précharge et de charge de la période de comptage ;
le premier signal de génération et le second signal de génération présentant une tension de réinitialisation durant une période de réinitialisation de sorte à fixer le signal logique d'entrée contrôlé à la tension de réinitialisation durant une période de réinitialisation.

Ce mode de réalisation vise à introduire un multiplexeur à deux transistors et deux signaux d'entrée, un pour la fonction « comptage » et un pour la fonction « non comptage ». L'un de ces deux signaux est envoyé au compteur en fonction du positionnement du signal d'entrée qui doit rester stable pendant le comptage, et peut évoluer entre deux comptages.

Lors de la période de réinitialisation, l'un des deux transistors de génération est forcément passant, indépendamment du niveau du signal d'entrée non-contrôlé, puisque le premier transistor de génération est commandé par le signal logique d'entrée non-contrôlé alors que le second transistor de génération est commandé par le signal complémentaire. Il s'ensuit que la tension recherchée, c'est-à-dire la tension de réinitialisation, est appliquée sur le signal logique d'entrée durant cette période de réinitialisation.

Ce mode de réalisation peut être mis en œuvre avec ou sans la capacité d'offset.

Ainsi, outre le signal logique d'entrée, tous les autres signaux sont générés à l'extérieur de la matrice, en particulier la tension spécifique appliquée lors de la période de réinitialisation. Cela impose néanmoins que tous les compteurs de la matrice se réinitialisent en même temps.

Par ailleurs, il est possible d'utiliser le transistor de transfert pour assurer une fonction cascode avec le transistor de contrôle d'injection. Cette fonction cascode permet de séparer le nœud d'injection et le nœud d'aiguillage pour assurer une linéarité du transfert des charges entre la capacité d'injection et la capacité d'intégration. Pour ce faire, le circuit de génération de signaux de commande est configuré pour transmettre un signal d'horloge sur le transistor de transfert dont l'amplitude est limitée de sorte que le transistor de transfert ne soit pas en régime ohmique dans les phases de précharge et de charge.

Par ailleurs, le circuit de remise à zéro peut être réalisé par un transistor dont le drain est connecté à la capacité d'intégration, la source est connectée à une tension d'initialisation et la grille est commandée par un signal de remise à zéro généré par le circuit de génération de signaux de commande du compteur. Ce mode de réalisation permet d'implémenter simplement une remise à zéro de la tension aux bornes de la capacité d'intégration. Au sens de l'invention, une remise à zéro fait référence à un positionnement de la tension de sortie analogique à une valeur correspondant à la valeur 0 du compteur d'évènement.

Ainsi, la remise à zéro peut consister à imposer un niveau de tension supérieur à 0 volt aux bornes de la capacité d'intégration, par exemple 3 Volts. De préférence, la capacité d'injection et/ou la capacité d'intégration sont réalisées par des capacités MOS. Une capacité MOS est classiquement réalisée en interposant une couche mince d'isolant de quelques dizaines de nanomètres entre un semi-conducteur, par exemple du silicium, et une électrode métallique, par exemple en silicium polycristallin. Ce mode de réalisation permet de limiter la surface de silicium nécessaire pour former les capacités.

Selon une première variante d'implémentation, le transistor de contrôle d'injection, les deux transistors de transfert, le transistor d'évacuation et le transistor de comptage sont constitués de transistor NMOS, la première tension de polarisation et la seconde tension de polarisation correspondant à des niveaux bas de tension alors que la troisième tension de polarisation correspondant à un niveau haut de tension. Cette première variante d'implémentation propose des diminutions successives d'une tension de sortie, initialement fixée à un état haut.

Selon une seconde variante d'implémentation, le transistor de contrôle d'injection, les deux transistors de transfert, le transistor d'évacuation et le transistor de comptage sont constituées de transistors PMOS, la première tension de polarisation et la seconde tension de polarisation correspondant à des niveaux haut de tension alors que la troisième tension de polarisation correspondant à un niveau bas de tension. Cette seconde variante d'implémentation propose des augmentations successives d'une tension de sortie, initialement fixée à un état bas.

### DESCRIPTION SOMMAIRE DES FIGURES

La manière de réaliser l'invention ainsi que les avantages qui en découlent, ressortiront bien des modes de réalisation qui suivent, donnés à titre indicatif mais non limitatif, à l'appui dans figures 1 à 8 dans lesquelles :
La figure 1 est une représentation schématique d'un compteur analogique de l'état de la technique ;
La figure 2 est une représentation schématique d'un compteur analogique selon un premier mode de réalisation de l'invention ;
La figure 3 est une représentation schématique d'un compteur analogique selon un deuxième mode de réalisation de l'invention ;
La figure 4 est une représentation schématique d'un compteur analogique selon un troisième mode de réalisation de l'invention ;
La figure 5 est une représentation schématique des signaux de commande et des tensions du compteur analogique de la figure 2 selon une première échelle de temps ;
La figure 6 est une représentation schématique d'une première partie des signaux de commande et des tensions du compteur analogique de la figure 4 ;
La figure 7 est une représentation schématique d'une seconde partie des signaux de commande et des tensions du compteur analogique de la figure 4 ;
La figure 8 est une représentation schématique d'une première partie des signaux de commande et des tensions du compteur analogique de la figure 4 dans un épisode de charge d'une période de réinitialisation ;
La figure 9 est une représentation schématique d'une seconde partie des signaux de commande et des tensions du compteur analogique de la figure 4 dans un épisode de charge de la période de réinitialisation ;
La figure 10 est une représentation schématique d'une première partie des signaux de commande et des tensions du compteur analogique de la figure 4 dans un épisode d'échantillonnage de la période de réinitialisation ; et
La figure 11 est une représentation schématique d'une seconde partie des signaux de commande et des tensions du compteur analogique de la figure 4 dans un épisode d'échantillonnage de la période de réinitialisation.

### DESCRIPTION DETAILLEE DE L'INVENTION

La figure 2 illustre un compteur analogique **10** selon un mode de réalisation de l'invention. Au sein de ce compteur analogique **10,** un circuit électronique permet de compter le nombre d'événements d'un signal logique d'entrée **vp** ou **vn** survenus au cours d'une période de comptage **Pc.** Pour ce faire, le circuit électronique est divisé en plusieurs parties :
- un circuit de génération périodique d'une quantité calibrée de charge **15,**
- un circuit d'aiguillage **16,**
- un circuit de génération de signaux de commande **17** et
- un circuit de remise à zéro **18.**

Ces différents circuits **15** à **18** visent à commander le stockage d'une quantité de charges prédéterminée dans chaque cycle de détection **Cd** de la période de comptage **Pc** lorsqu'un événement est détecté sur le signal logique d'entrée **vp** ou **vn.** Ces quantités calibrées de charges sont stockées dans une capacité d'intégration **Cint** montée entre une tension de sortie **Vint** et la masse.

Le circuit de remise à zéro **18** permet de réinitialiser la tension de sortie **Vint** aux bornes de la capacité d'intégration **Cint** au moyen d'un signal **reset.** Pour ce faire, le circuit de remise à zéro **18** peut être réalisé au moyen d'un transistor **Mr** de type PMOS dont le drain est connecté à la tension **Vint** et la source est connectée à une tension d'initialisation **Vinit** correspondant à la tension à appliquer à la tension de sortie **Vint** pour réinitialiser le compteur analogique **10.**

La grille du transistor **Mr** est commandée par un signal de remise à zéro **reset** généré par le circuit de génération de signaux de commande **17.** Par exemple, la tension **Vinit** peut correspondre à une tension de 3 Volts permettant de réinitialiser la tension **Vint** aux bornes de la capacité d'intégration **Cint** à 3 Volts au début du comptage. Ce circuit de remise à zéro **18** peut prendre d'autres formes sans changer l'invention.

Pour générer des charges calibrées lors de chaque cycle de détection **Cd,** l'invention propose d'implémenter un circuit de génération périodique **15** d'une quantité calibrée de charges comportant une capacité d'injection **Cinj,** un transistor de contrôle d'injection **Mct,** un transistor de charge **Mc** et un transistor de transfert **Mt.** La capacité d'injection **Cinj,** ainsi que la capacité d'intégration **Cint,** peuvent être réalisées par des capacités MOS. Contrairement à la capacité d'intégration **Cint** qui vise à stocker plusieurs quantités de charges distinctes afin de compter les événements survenus sur le signal logique d'entrée **vp** ou **vn,** la capacité d'injection **Cinj** peut présenter une valeur de capacité beaucoup plus faible que celle de la capacité d'intégration **Cint.** L'ordre de grandeur de la capacité d'injection **Cinj** est la dizaine de femtofarad, par exemple 10 fF, alors que l'ordre de grandeur de la capacité d'intégration **Cint** est la centaine de femtofarad, par exemple 500 fF.

Cette capacité d'injection **Cinj** est connectée à l'une de ses bornes à une première tension de polarisation **Vpol1,** alors que l'autre borne de la capacité d'injection **Cinj** est connectée au transistor de contrôle d'injection **Mct.** Dans l'exemple de la figure 2, le transistor de contrôle d'injection **Mct** est constitué d'un transistor NMOS, dont la source est connectée à la capacité d'injection **Cinj** alors que le drain est connecté à un nœud d'injection **N1.** Par ailleurs, la grille du transistor de contrôle d'injection **Mct** est connectée à une tension de commande **vt** générée par le circuit de génération de signaux de commande **17.**

Le nœud d'injection **N1** est également connecté au transistor de charge **Mc** et au transistor de transfert **Mt.** Plus précisément, le transistor de charge **Mc** est connecté entre le nœud d'injection **N1** et une seconde tension de polarisation **Vpol2.**

Dans l'exemple de la figure 2, le transistor de charge **Mc** est constitué d'un transistor NMOS dont la source est connectée à la seconde tension de polarisation **Vpol2,** et dont le drain est connecté au nœud d'injection **N1**. Le transistor de transfert **Mt** est quant à lui connecté entre le nœud d'injection **N1** et un nœud d'aiguillage **N2.** Dans l'exemple de la figure 2, le transistor de transfert **Mt** est constitué d'un transistor NMOS, dont la source est connectée au nœud d'injection **N1** et dont le drain est connecté au nœud d'aiguillage **N2.**

Les deux transistors de charge et de transfert **Mc** et **Mt** sont commandés par des signaux d'horloge **Φ** et /**Φ** en opposition de phase. Ces signaux d'horloge **Φ** et /**Φ** sont également générés par le circuit de génération de signaux de commande **17.**

Ainsi, dans l'exemple de la figure 2, le circuit de génération de signaux de commande **17** génère les signaux de commande **Φ**, /**Φ**, **vt** et **reset** qui permettent de configurer le compteur analogique **10.**

Pour détecter les événements sur un signal logique d'entrée **vp** ou **vn,** ce signal logique d'entrée est pris en considération dans le circuit d'aiguillage **16.** Ce circuit d'aiguillage **16** permet de transférer les charges calibrées de la capacité d'injection **Cinj** dans la capacité d'intégration **Cint** lorsque le comptage est validé par le signal logique d'entrée **vp** ou **vn** ou d'évacuer ses charges vers une troisième tension de polarisation **Vpol3.** Pour ce faire, le circuit d'aiguillage **16** comprend préférentiellement deux lignes **L1** et **L2.** Une ligne d'évacuation des charges **L1** est formée par un transistor d'évacuation **Md1**. Dans l'exemple de la figure 2, le transistor d'évacuation **Md1** est constitué d'un transistor NMOS dont la source est connectée sur le nœud d'aiguillage **N2** et dont le drain est connecté à la troisième tension de polarisation **Vpol3.**

La seconde ligne correspond à une ligne de transfert de charges **L2** qui comporte un transistor de comptage **Md2.** Dans l'exemple de la figure 2, le transistor de comptage **Md2** est constitué d'un transistor NMOS dont la source est connectée sur le nœud d'aiguillage **N2** et dont le drain est connecté à la tension de sortie **Vint,** c'est-à-dire à la capacité d'intégration **Cint.**

La grille des transistors **Md1** et **Md2** est commandée par deux signaux logiques d'entrée **vp** et **vn** qui déterminent si les charges stockées dans la capacité d'injection **Cinj** sont évacuées ou transférées dans la capacité d'intégration **Cint.** Plus précisément, ces deux signaux logiques d'entrée **vp** et **vn** fonctionnent comme une paire différentielle, et c'est la différence entre ces deux signaux logiques d'entrée **vp** et **vn** qui déterminent si les charges stockées dans la capacité d'injection **Cinj** sont évacuées ou transférées dans la capacité d'intégration **Cint.** Ainsi, en plaçant le signal logique d'entrée **vn** à une valeur fixe, il est possible de définir si les charges stockées dans la capacité d'injection **Cinj** sont évacuées ou transférées, simplement en modifiant l'état du signal logique d'entrée **vp.**

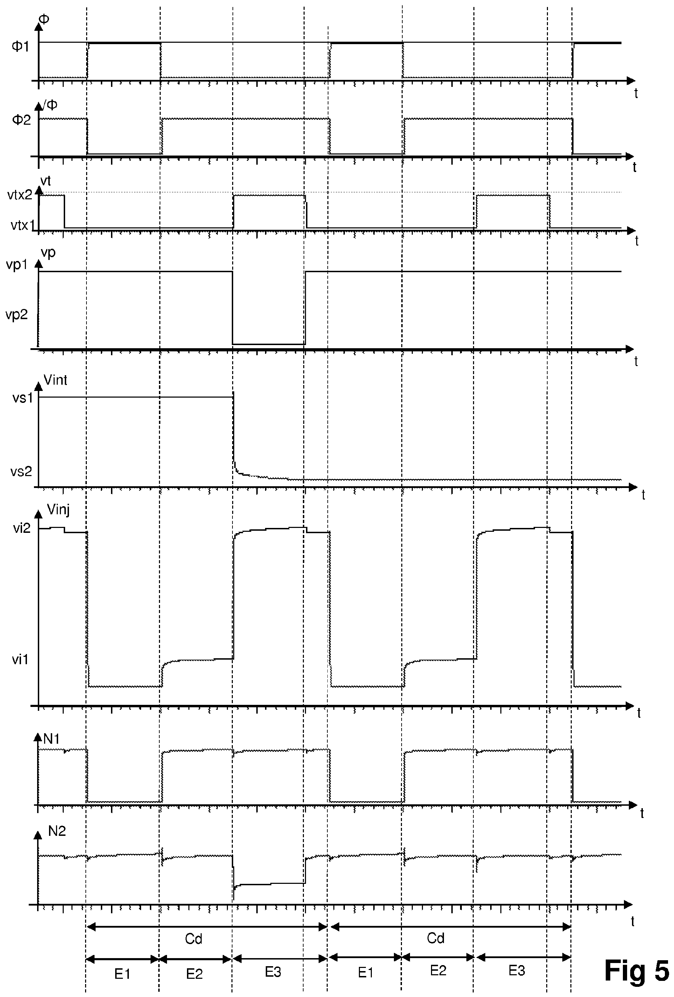

Le fonctionnement de ce circuit de la figure 2 est plus particulièrement décrit en référence avec la figure 5 qui illustre un exemple de mise en œuvre de deux cycles de détection **Cd** au cours d'une période de comptage **Pc.** Chaque cycle de détection **Cd** comporte trois phases.

Une phase d'initialisation **E1** permet de charger la capacité d'injection **Cinj.** Lors de cette phase, le transistor de contrôle d'injection **Mct** et le transistor de charge **Mc** sont passants alors que le transistor de transfert **Mt** est bloqué. Pour commander cette phase d'initialisation **E1**, le signal d'horloge **Φ** est placé à l'état haut alors que le signal d'horloge /**Φ** est placé à l'état bas. La durée de cette phase d'initialisation **E1** est sélectionnée pour que la capacité d'injection **Cinj** puisse être complètement chargée.

Après cette phase initialisation **E1**, une phase de précharge **E2** consiste à placer le transistor de contrôle d'injection **Mct** et le transistor de transfert **Mt** passants, alors que le transistor de charge **Mc** est bloqué. Ainsi, cette phase de précharge **E2** est obtenue en passant le signal **Φ** à l'état bas et le signal d'horloge /**Φ** à l'état haut. Par ailleurs, dans cette phase de précharge **E2,** la tension de commande **vt** est fixée à une première valeur **vtx1**. Suite à cette phase de précharge **E2,** une phase de charge **E3** consiste à modifier la tension de commande **vt** à une seconde valeur **vtx2** afin d'appliquer une discontinuité de tension aux bornes de la capacité d'injection **Cinj.**

Cette discontinuité de tension entre la phase de précharge **E2** et la phase de charge **E3** entraîne un transfert de charges commandé par la variation de tension appliquée sur le signal de commande **vt.**

Plus précisément, dans la phase de précharge **E2,** la capacité **Cinj** se décharge progressivement jusqu' à ce que la tension **Vinj** aux bornes de cette capacité soit polarisée à **vtx1-vtMct,** avec **vtMct** correspondant à la tension de seuil du transistor de contrôle d'injection **Mct.** En appliquant un second niveau de tension **vtx2** > **vtx1** lors de la phase de charge **E3,** la capacité **Cinj** se décharge et le signal **Vinj** passe de **vtx1-vtMct** à **vtx2-vtMct,** la quantité de charges transférée est alors exactement **vtx2-vtx1** divisé par la valeur de capacité de la capacité **Cinj.**

La tension de seuil du transistor de contrôle d'injection **vtMct** évolue légèrement, par effet bulk, avec la polarisation de la source du transistor de contrôle d'injection **Vinj,** cet effet réduit très légèrement la valeur de la charge transférée par rapport à la théorie, mais la dégradation de la précision de la charge transférée est du second ordre.

Dans l'exemple de la figure 5, lors du premier cycle de détection **Cd,** le signal **vp** passe de la valeur **vp1** à **vp2** avant que le signal de commande **vt** passe de la valeur **vtx1** à **vtx2.**

Ainsi, le signal **vp** est à l'état bas **vp2** lors de la transition entre la phase de précharge **E2** et la phase de charge **E3.** Ce niveau de tension du signal logique d'entrée **vp** induit un comptage, c'est-à-dire un transfert de charges depuis la capacité d'injection **Cinj** vers la capacité d'intégration **Cint.** Il s'ensuit que la valeur **Vint** aux bornes de la capacité d'intégration **Cint** est diminuée depuis la tension **vs1** à la tension **vs2** lors de ce comptage.

Lors du second cycle de détection **Cd** illustré sur la figure 5, lorsque le signal **vt** passe de la tension **vtx1** à **vtx2,** aucun évènement n'apparait sur le signal d'entrée **vp** et le signal **vp** reste à l'état haut. Il s'ensuit que les charges sont évacuées vers la troisième tension de polarisation **Vpol3** et que la tension de sortie **Vint** n'est pas modifiée.

La tension **Vinj** aux bornes de la capacité d'injection **Cinj** illustre bien les deux phases de décharge de cette capacité d'injection avec les niveaux de tension **Vi1** et **Vi2** qui résultent des phases de précharge **E2** et des phases de charge **E3.** De même, l'évolution de la tension sur les nœuds d'injection **N1** et d'aiguillage **N2** illustre également l'évolution de la tension dans le circuit de la figure 2 selon qu'il y a ou non un transfert des charges de la capacité d'injection **Cinj** vers la capacité d'intégration **Cint.**

Pour assurer les décharges nécessaires de la capacité d'injection **Cinj** dans les phases de précharge **E2** et de charge **E3,** et assurer la précision de la charge transférée pour le comptage, la durée de convergence de la décharge de la capacité d'injection **Cinj** peut être choisie identique dans les phases de précharge **E2** et de charge **E3.** Cette durée est définie entre le début de la phase **E2** et l'instant de commutation de **vp** entre **vp1** et **vp2.**

Outre la forme des signaux visibles sur cette figure 5 et permettant de commander le compteur **10** de la figure 2, il est à noter que l'amplitude du signal d'horloge /**Φ** peut également être réglée pour que le transistor de transfert **Mt** assure une fonction cascode avec le transistor de contrôle d'injection **Mct.** Ainsi, ce transistor de transfert **Mt** n'est pas en régime ohmique. Typiquement, le signal **Φ** peut évoluer entre 0 et 5 Volts alors que le signal /**Φ** peut évoluer entre 0 et 2,1 Volts. La tension **vt** peut quant à elle évoluer entre la tension **vtx1** comprise entre 0,7 et 1,1 Volt et la tension **vtx2** comprise entre 1,5 et 1,9 Volts. En fixant le signal **vn** entre 2,3 et 2,5 Volts, le signal **vp** peut évoluer à l'état haut entre 2,6 et 2,9 Volts et à l'état bas entre 1,9 et 2,2 Volts.

Bien entendu, le schéma de la figure 2 est illustré avec des transistors NMOS et la première et la seconde tension de polarisation **Vpol1** et **Vpol2** sont fixées à la masse alors que la troisième tension de polarisation **Vpol3** correspond un niveau de tension haut, par exemple 5 Volts. Comme il est connu dans la technologie CMOS, il est possible de réaliser un circuit équivalent en utilisant des transistors PMOS pour former le transistor de contrôle d'injection **Mct,** les deux transistors de transfert **Mc** et **Mt,** et les deux transistors **Md1** et **Md2** du circuit d'aiguillage **16.** Pour ce faire, la première et la seconde tension de polarisation **Vpol1** et **Vpol2** correspondent à des niveaux hauts de tension alors que la troisième tension de polarisation **Vpol3** est fixée à la masse.

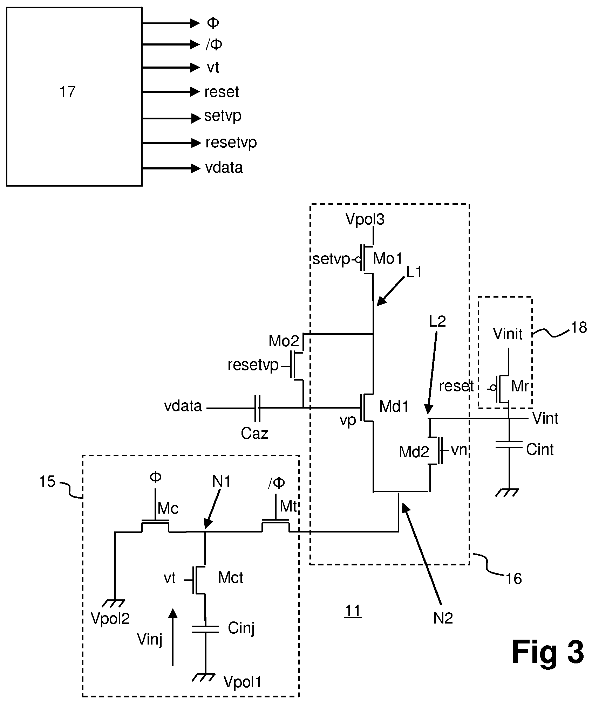

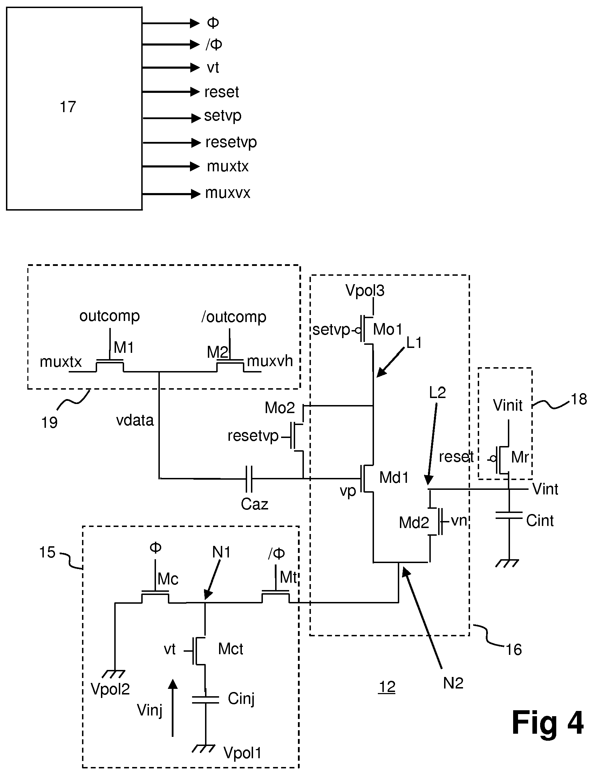

Outre le schéma générique de l'invention illustré sur la figure 2, plusieurs améliorations à ce schéma sont possibles et illustrées sur les figures 3 et 4.

Dans le mode de réalisation de la figure 3, la ligne d'évacuation des charges **L1** comprend également une capacité d'offset **Caz,** un premier transistor d'offset **Mo1** et un second transistor d'offset **Mo2.** Plus précisément, la capacité d'offset **Caz** est connectée entre un signal logique d'entrée contrôlé **vdata** et la grille du transistor d'évacuation **Md1**. Ainsi, le signal logique d'entrée **vp** est obtenu à partir du signal logique d'entrée contrôlé **vdata** en appliquant un offset fixé dans la capacité d'offset **Caz.** Le premier transistor d'offset **Mo1** est monté entre le transistor d'évacuation **Md1** et la troisième tension de polarisation **Vpol3.**

Plus précisément, dans l'exemple de la figure 3, le premier transistor d'offset **Mo1** est constitué d'un transistor PMOS dont le drain est connecté au drain du transistor d'évacuation **Md1,** dont la source est connectée à la troisième tension de polarisation **Vpol3,** et dont la grille est commandée par un premier signal d'offset **setvp** généré par le circuit de génération de signaux de commande.

Le second transistor d'offset est quant à lui monté entre le drain et la grille du transistor d'évacuation **Md1**. Dans l'exemple de la figure 3, le drain du second transistor d'offset est connecté au drain du transistor d'évacuation **Md1,** et sa source est connectée à la grille du transistor d'évacuation **Md1**. La grille de ce second transistor d'offset **Mo2** est également commandée par un second signal d'offset **resetvp** généré par le circuit **17.**

Ainsi, dans le mode de réalisation de la figure 3, le circuit **17** génère également les signaux **setvp, resetvp** et **vdata** car il convient de contrôler le niveau de tension du signal logique d'entrée contrôlé **vdata** dans une période de réinitialisation **Pr.** Cette période de réinitialisation **Pr** est mise en œuvre avant la période de comptage **Pc** au cours de laquelle les multiples cycles de détection **Cd** ont précédemment été décrits.

Dans l'exemple de la figure 2, cette période de réinitialisation **Pr** consiste simplement à activer le signal **reset** pendant une durée suffisante pour charger la capacité d'intégration **Cint** à la valeur initiale. Avec le circuit de la figure 3, cette période de réinitialisation **Pr** peut également être utilisée pour fixer la tension aux bornes de la capacité d'offset **Caz** en stockant une quantité de charges prédéterminée dans cette capacité d'offset **Caz.** Cette capacité d'offset **Caz** est utilisée pour stocker une quantité de charges correspondant à la différence entre les tensions de seuil des transistors **Md1** et **Md2** de sorte à soustraire cette valeur d'offset pour commander le comptage ou non par le signal d'entrée **vp.** Ce faisant, l'offset de la paire différentielle formée par les lignes **L1** et **L2** peut être annulé au cours de la période de comptage **Pc.**

Pour ce faire, la période de réinitialisation **Pr** comporte trois épisodes distincts : un épisode de charge **P1**, un épisode de décharge **P2** et un épisode d'échantillonnage **P3.**

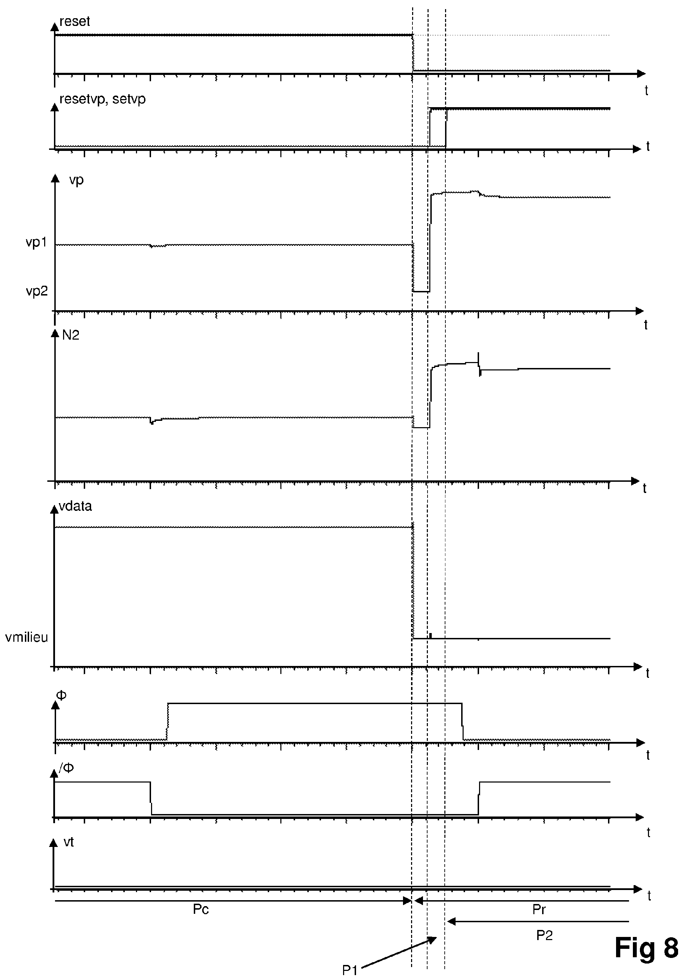

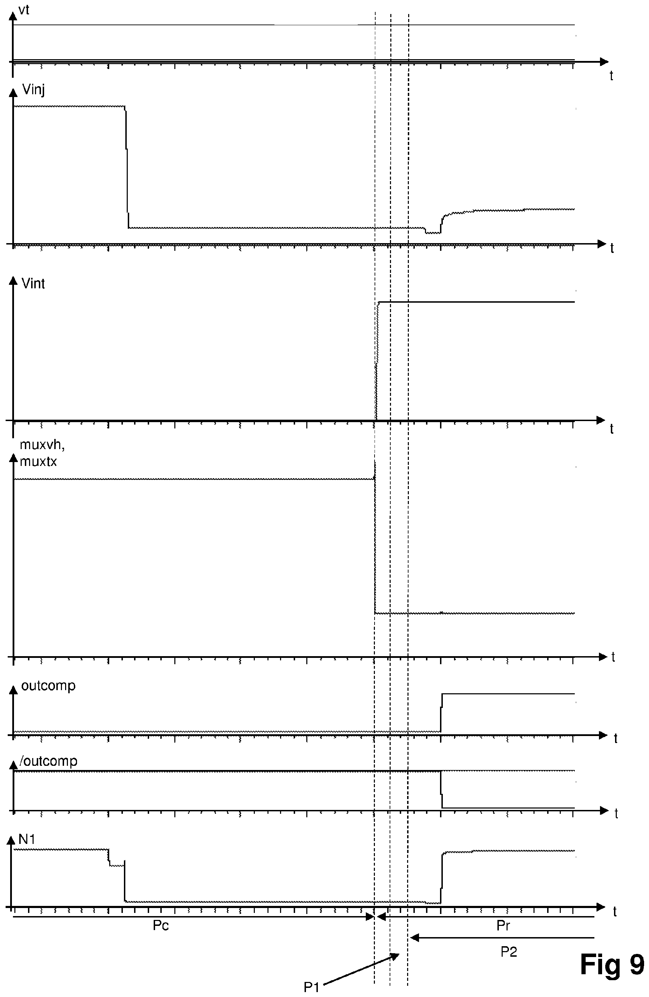

L'épisode de charge **P1** vise simplement à charger la capacité d'offset **Caz** à une première valeur d'initialisation. Dans cet épisode de charge **P1**, tel qu'illustré sur les figures 8 et 9, le premier transistor d'offset **Mo1** est passant et le second transistor d'offset **Mo2** est passant.

Ensuite, dans l'épisode de décharge **P2,** le premier transistor d'offset **Mo1** est bloqué alors que le second transistor d'offset **Mo2** est passant. Cet épisode de décharge **P2** est maintenu pendant un certain nombre de cycles de calibration **Cc** au cours desquels les phases d'initialisation **E1**, de précharge **E2** et de charges **E3** sont mises en œuvre.

Lors de l'épisode d'échantillonnage **P3,** le premier transistor d'offset **Mo1** est bloqué et le second transistor d'offset **Mo2** est bloqué.

Pour obtenir un transfert de charges successif depuis la capacité d'injection **Cinj** vers la capacité d'offset **Caz** au cours de la période de réinitialisation **Pr,** le signal logique d'entrée contrôlé **vdata** est fixé à une valeur de tension de réinitialisation **vmilieu.** Par exemple, la tension **vdata** peut être fixée à une tension comprise entre 0,1 et 0,3 Volts.

En dehors de la période de réinitialisation **Pr** au cours de laquelle des charges sont successivement stockées dans la capacité d'offset **Caz,** les signaux **setvp** et **resetvp** sont commandés de telle sorte que le premier transistor d'offset **Mo1** soit passant et le second transistor d'offset **Mo2** soit bloqué dans la période de comptage.

Pour pouvoir gérer l'application de la tension **vdata** depuis des signaux communs à l'ensemble d'une matrice de compteurs, le compteur analogique **11** de la figure 3 peut être amélioré avec le schéma du compteur analogique **12** de la figure 4, dans lequel un circuit de génération du signal logique d'entrée variable **19** est proposé.

Ce circuit **19** comprend un premier transistor de génération **M1** et un second transistor de génération **M2** fonctionnant en commutation. Dans l'exemple de la figure 4 mettant en œuvre des transistors NMOS, la première borne, source ou drain, du transistor **M1** est connectée à un premier signal de génération **muxtx** alors que la seconde borne, source ou drain, de ce transistor **M1** est connectée au signal d'entrée **vdata.** La seconde borne, source ou drain, du transistor **M2** est également connectée au signal d'entrée **vdata** alors que sa première borne, source ou drain, est connectée à un second signal de génération **muxvh.**

Le signal d'entrée **outcomp** peut ainsi être injecté sur la grille des transistors **M1** et **M2** ; en utilisant le signal **outcomp** sur la grille du transistor **M1** et le signal inverse /**outcomp** sur la grille du transistor **M2.**

Dans ce mode de réalisation, le circuit de génération de signaux de commande **17** génère les signaux **muxtx** et **muxvh** de sorte à placer le signal **muxtx** à l'état bas dans la phase de charge **E3** et à l'état haut dans les phases d'initialisation **E1** et de précharge **E2** de la période de comptage **Pc.** Le signal de génération **muxvh** est quant à lui placé à l'état haut dans les phases d'initialisation **E1**, de précharge **E2** et de charge **E3** de la période de comptage **Pc.** Lors de la période de réinitialisation **Pr,** le premier signal de génération **muxtx** et le second signal de génération **muxvh** sont fixés à un niveau de tension spécifique vmilieu pour positionner la tension de réinitialisation **vmilieu** sur le signal logique d'entrée **vdata.**

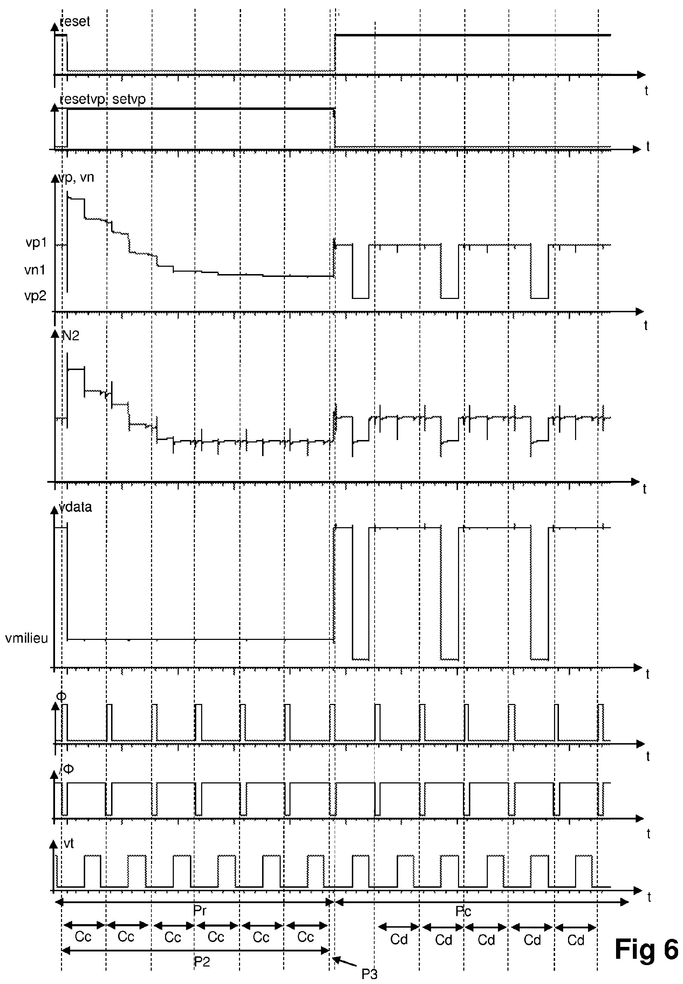

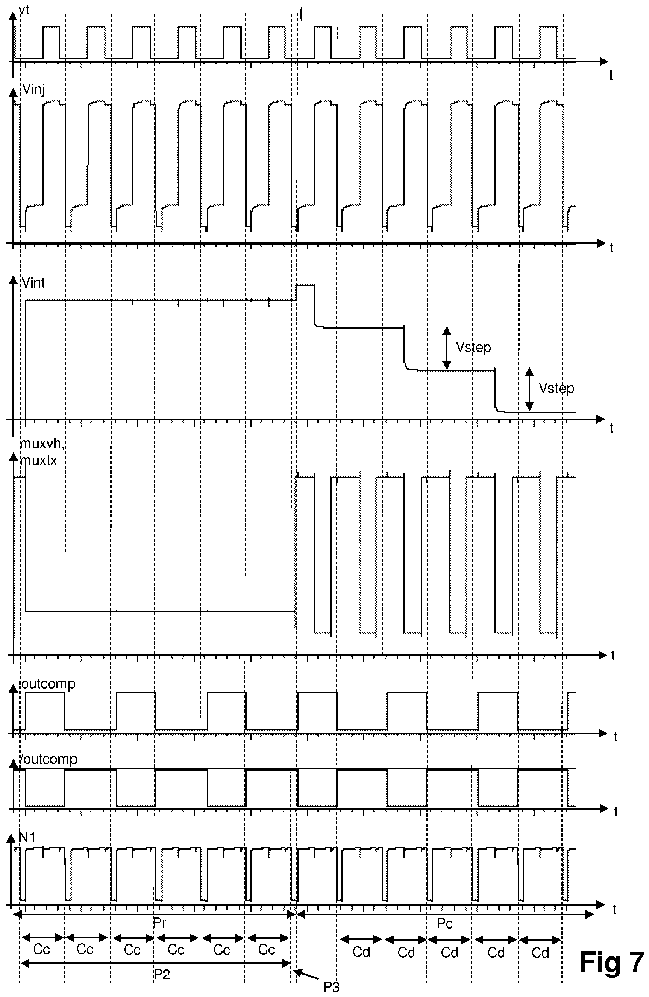

La transition entre la période de réinitialisation **Pr** et la période de comptage **Pc** est plus particulièrement illustrée avec les chronogrammes des signaux des figures 6 et 7. Ces signaux illustrent comment l'offset du signal **vp** évolue à mesure des cycles de calibration **Cc** permettent l'injection des charges calibrées dans la capacité d'injection **Cinj** vers la capacité d'offset **Caz.** Après les six cycles de calibration illustrés sur les figures 6 et 7, la tension **vp** est quasiment stable et cette tension **vp** présente un offset de quelques millivolts dans la période de comptage **Pc.** Cet offset est représentatif de la différence des tensions de seuil des transistors Md1 et Md2, il permet d'annuler par soustraction durant la période de comptage Pc, la dégradation induite par cette différence de tension de seuil sur la précision de la charge transféré dans la capacité Cint.

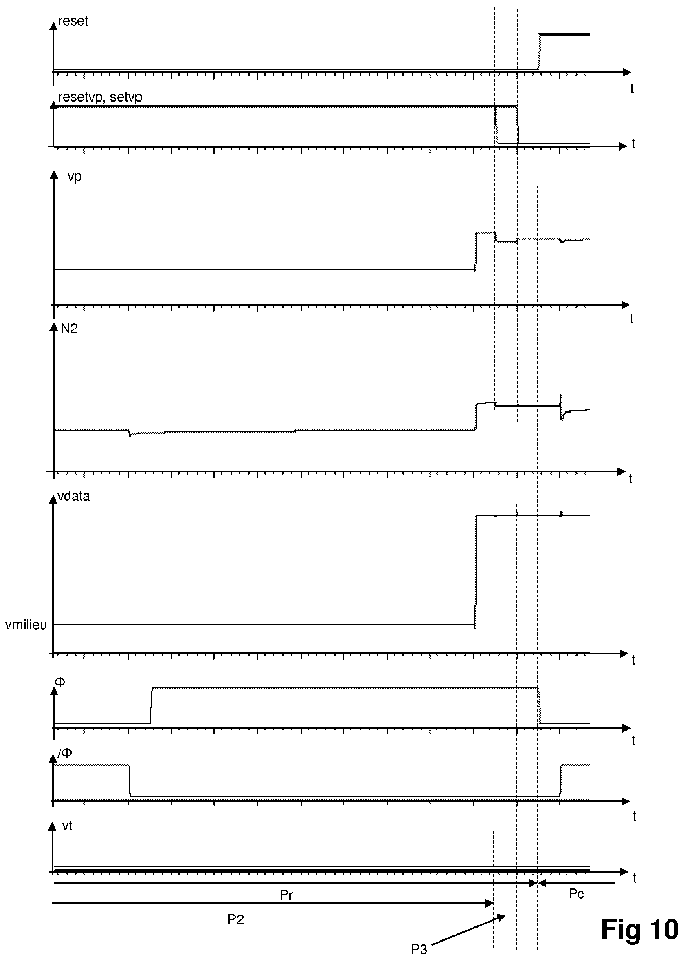

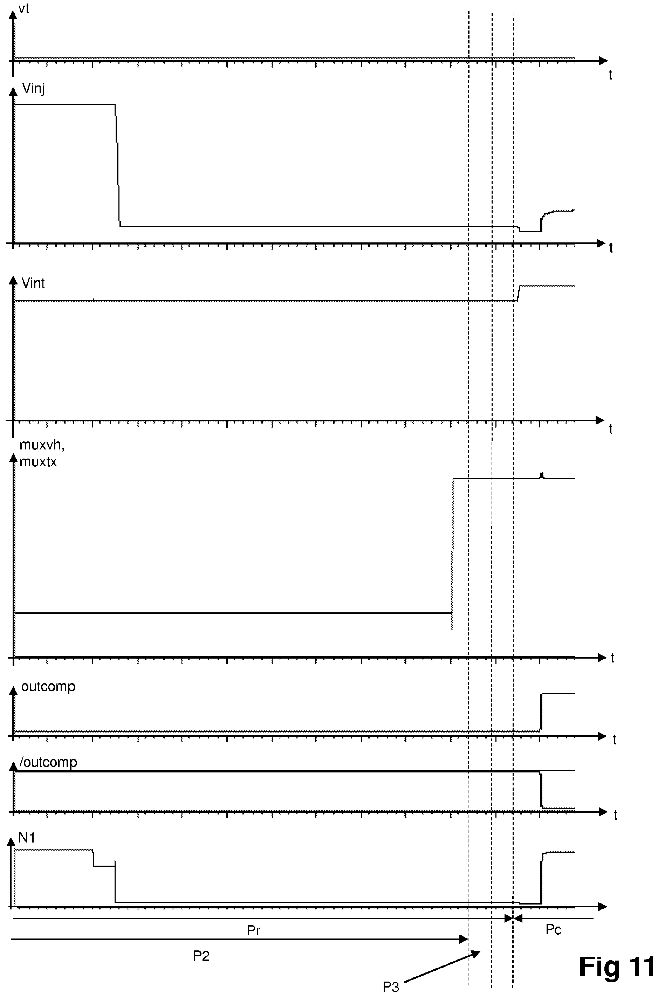

Tel qu'illustré sur les figures 6 et 7, les cycles de calibration **Cc** peuvent présenter une durée sensiblement similaire aux cycles de détection **Cd** et, ainsi, intégrer les mêmes phases **E1** à **E3.** Pour former l'épisode **P3,** tel qu'illustré sur les figures 10 et 11, les signaux **resetvp** et **setvp** ne sont pas synchronisés et il y a un petit décalage temporel pour échantillonner, dans la capacité **Caz,** la valeur de la tension **vp** obtenue à la fin de l'épisode **P2.** Cet échantillonnage est suivi par le positionnement des tensions correspondant à la période de comptage **Pc.**

Par ailleurs, les figures 6 et 7 illustrent plusieurs cycles de détection **Cd** au cours desquels le signal d'entrée **outcomp** est activé. Il s'ensuit que la tension de sortie **Vint** aux bornes de la capacité d'intégration **Cint** diminue plusieurs fois sur les chronogrammes des figures 6 et 7. A chaque diminution de cette tension **vp,** un différentiel de tension **Vstep** est visible sur la tension de sorties **Vint.** Ce différentiel de tension peut être particulièrement faible avec l'invention, de sorte à obtenir un compteur analogique 7 ou 8 bits. Typiquement, ce différentiel de tension **Vstep** peut-être compris entre 20 et 30 millivolts.

L'invention permet donc d'obtenir un compteur analogique **10-12** plus précis que les compteurs analogiques connus car il ne dépend pas au premier ordre des paramètres technologiques de la technologie utilisée, tels que la dispersion des tensions de seuil des transistors, ou la valeur des capacités. Ainsi, l'invention permet d'obtenir un compteur analogique **10-12** avec une précision de 7 ou 8 bits. En outre le compteur analogique **10-12** peut être réalisé par des composants CMOS permettant une intégration du compteur analogique **10-12** dans une surface de silicium restreinte. Ainsi, le compteur analogique **10-12** de l'invention peut être intégré dans chaque pixel d'une matrice, par exemple pour les capteurs utilisant des photodiodes à avalanche mono-photonique.

## Revendications

1. Compteur analogique (10-12) du nombre d'évènements d'au moins un signal logique d'entrée (vp, vn, vdata, outcomp) au cours d'une période de comptage (Pc), ladite période de comptage (Pc) comportant un ensemble de cycles de détection (Cd) au cours desquels un évènement du signal logique d'entrée (vp, vn, vdata, outcomp) peut être détecté, le compteur analogique (10-12) comprenant :
▪ un circuit de génération périodique d'une quantité calibrée de charges (15) pour chaque cycle de détection (Cd) ;
▪ une capacité d'intégration (Cint) configurée pour stocker ladite quantité calibrée de charges lors de chaque cycle de détection (Cd) de la période de comptage (Pc) pour lequel un évènement du signal logique d'entrée (vp, vn, vdata, outcomp) est détecté de sorte qu'une tension de sortie (Vint), aux bornes de la capacité d'intégration (Cint), est représentative du nombre d'évènements du signal logique d'entrée (vp, vn, vdata, outcomp) détectés au cours de la période de comptage (Pc) ;
▪ un circuit d'aiguillage (16) de la quantité calibrée de charges commandé par le signal logique d'entrée (vp, vn, vdata, outcomp) pour stocker ladite quantité calibrée de charges dans la capacité d'intégration (Cint) uniquement lorsqu'un évènement est détecté sur le signal logique d'entrée (vp, vn, vdata, outcomp) ;
▪ un circuit de génération de signaux de commande (17) du compteur analogique (10-12) ; et
▪ un circuit de remise à zéro (18) de la tension de sortie (Vint) aux bornes de la capacité d'intégration (Cint) de sorte à réinitialiser le comptage ;
le circuit de génération périodique d'une quantité calibrée de charges (15) comprenant :
▪ une capacité d'injection (Cinj) configurée pour stocker la quantité calibrée de charges lors de chaque cycle de détection (Cd) et connectée par l'une de ses bornes à une première tension de polarisation (Vpol1) ;
▪ un transistor de charge (Mc) dont la source est connectée à une seconde tension de polarisation (Vpol2) et dont le drain est connecté au nœud d'injection (N1) ; et
▪ un transistor de transfert (Mt) dont la source est connectée au nœud d'injection (N1) et dont le drain est connecté à un nœud d'aiguillage (N2) ;
**caractérisé en ce que** :
le circuit de génération périodique d'une quantité calibrée de charges (15) comprend un transistor de contrôle d'injection (Mct) dont la source est connectée à l'autre borne de la capacité d'injection (Cinj), dont la grille est connectée à une tension de commande (Vt), et dont le drain est connecté à un nœud d'injection (N1) ;
la grille des deux transistors de charge et de transfert (Mc, Mt) étant commandée par des signaux d'horloge (Φ, /Φ) en opposition de phase de sorte à charger ladite capacité d'injection (Cinj), puis à transférer les charges accumulées dans ladite capacité d'injection (Cinj) au circuit d'aiguillage (16) ;
le circuit de génération de signaux de commande (17) étant configuré pour commander la tension de commande (Vt) et les signaux d'horloge (Φ, /Φ) de sorte à générer successivement les phases suivantes à chaque cycle de détection (Cd) :
▪ une phase d'initialisation (E1) au cours de laquelle le transistor de contrôle d'injection (Mct) et le transistor de charge (Mc) sont passants alors que le transistor de transfert (Mt) est bloqué ;
▪ une phase de précharge (E2) au cours de laquelle le transistor de contrôle d'injection (Mct) et le transistor de transfert (Mt) sont passants alors que le transistor de charge (Mc) est bloqué, la tension de commande (Vt) étant fixée à une première valeur (vtx1) ; et
▪ une phase de charge (E3) au cours de laquelle le transistor de contrôle d'injection (Mct) et le transistor de transfert (Mt) sont passants alors que le transistor de charge (Mc) est bloqué, la tension de commande (Vt) étant fixée à une seconde valeur (vtx2).

2. Compteur analogique selon la revendication 1, ***dans lequel*** le circuit d'aiguillage (16) comprend deux lignes (L1, L2) :
▪ une ligne d'évacuation des charges (L1) comprenant un transistor d'évacuation (Md1) dont la source est connectée sur le nœud d'aiguillage (N2) et dont le drain est connecté à une troisième tension de polarisation (Vpol3) ; et
▪ une ligne de transfert des charges (L2) comprenant un transistor de comptage (Md2) dont la source est connectée sur ledit nœud d'aiguillage (N2) et dont le drain est connecté à la capacité d'intégration (Cint) ;
la grille des transistors (Md1, Md2) des deux lignes (L1, L2) étant commandée par des signaux logiques d'entrée (vp, vn, vdata, outcomp) qui déterminent si les charges stockées dans la capacité d'injection (Cinj) sont évacuées ou transférées dans la capacité d'intégration (Cint).

3. Compteur analogique selon la revendication 2, ***dans lequel*** le transistor de contrôle d'injection (Mct), les deux transistors de transfert (Mc, Mt), le transistor d'évacuation (Md1) et le transistor de comptage (Md2) sont constitués par des transistors NMOS, la première tension de polarisation (Vpol1) et la seconde tension de polarisation (Vpol2) correspondant à des niveaux bas de tension alors que la troisième tension de polarisation (Vpol3) correspond à un niveau haut de tension.

4. Compteur analogique selon la revendication 2, ***dans lequel*** le transistor de contrôle d'injection (Mct), les deux transistors de transfert (Mc, Mt), le transistor d'évacuation (Md1) et le transistor de comptage (Md2) sont constitués par des transistors PMOS, la première tension de polarisation (Vpol1) et la seconde tension de polarisation (Vpol2) correspondant à des niveaux haut de tension alors que la troisième tension de polarisation (Vpol3) correspond à un niveau bas de tension.

5. Compteur analogique selon l'une des revendications 2 à 4, ***dans lequel*** le transistor d'évacuation (Md1) de la ligne d'évacuation des charges (L1) est commandé par un signal logique d'entrée variable (vp), alors que le transistor de comptage (Md2) de la ligne de transfert des charges (L2) est commandé par un signal fixe (vn), de sorte qu'une activation du signal logique d'entrée variable (vp) dans la phase de charge (E3) entraine un transfert des charges calibrés dans la capacité d'intégration (Cint).

6. Compteur analogique selon la revendication 5, ***dans lequel*** la ligne d'évacuation des charges (L1) comprend également :
▪ une capacité d'offset (Caz) connectée entre un signal logique d'entrée contrôlé (vdata) et la grille du transistor d'évacuation (Md1) de sorte que le signal logique d'entrée variable (vp) est obtenu à partir du signal logique d'entrée contrôlé (vdata) en appliquant un offset généré par la tension de la capacité d'offset (Caz) ;
▪ un premier transistor d'offset (Mo1) monté entre le drain du transistor d'évacuation (Md1) et la troisième tension de polarisation (Vpol3), la source du premier transistor d'offset (Mo1) étant connectée à la troisième tension de polarisation (Vpol3), son drain étant connecté au drain du transistor d'évacuation (Md1) et sa grille étant commandée par un premier signal d'offset (setvp) généré par le circuit de génération de signaux de commande (17) ; et
▪ un second transistor d'offset (Mo2) monté entre le drain et la grille du transistor d'évacuation (Md1), le drain du second transistor d'offset (Mo2) étant connecté au drain du transistor d'évacuation (Md1), sa source étant connectée à la grille du transistor d'évacuation (Md1) et sa grille étant commandée par un second signal d'offset (resetvp) généré par le circuit de génération de signaux de commande (17) ;
le circuit de génération de signaux de commande (17) étant configuré pour commander le premier signal d'offset (setvp) et le second signal d'offset (resetvp) de sorte à générer successivement les épisodes suivants dans une période de réinitialisation (Pr) :
▪ un épisode de charge (P1) de la capacité d'offset (Caz) dans lequel le premier transistor d'offset (Mo1) est passant et le second transistor d'offset (Mo2) est passant ;
▪ un épisode de décharge (P2) de la capacité d'offset (Caz) dans lequel le premier transistor d'offset (Mo1) est bloqué et le second transistor d'offset (Mo2) est passant, cet épisode de décharge (P2) étant maintenu pendant un certain nombre de cycles de calibration (Cc) au cours desquels les phases d'initialisation (E1), de précharge (E2) et de charge (E3) sont mises en œuvre ; et
▪ un épisode d'échantillonnage (P3) de la capacité d'offset (Caz) dans lequel le premier transistor d'offset (Mo1) est bloqué et le second transistor d'offset (Mo2) est bloqué ;
le signal d'entrée logique contrôlé (vdata) étant fixé à une valeur de tension de réinitialisation (vmilieu) durant les épisodes de charge (P1), de décharge (P2) et d'échantillonnage (P3) ;
le circuit de génération de signaux de commande (17) étant configuré pour commander le premier signal d'offset (setvp) et le second signal d'offset (resetvp) de sorte que le premier transistor d'offset (Mo1) est passant et le second transistor d'offset (Mo2) est bloqué dans la période de comptage (Pc).

7. Compteur analogique selon l'une des revendications 2 à 6, ***dans lequel*** la ligne d'évacuation des charges (L1) comprend également un circuit de génération du signal logique d'entrée variable (19), ce dernier comprenant :
▪ un premier transistor de génération (M1) dont une première borne, source ou drain, est connectée à un premier signal de génération (muxtx), une seconde borne, source ou drain, est connectée au signal logique d'entrée (vp, vdata), et la grille est connectée à un signal logique d'entrée non-contrôlé (outcomp) ; et
▪ un second transistor de génération (M2) dont une première borne, source ou drain, est connectée à un second signal de génération (muxvh), une seconde borne, source ou drain, est connectée au signal logique d'entrée contrôlé (vp, vdata), et la grille est connectée à un signal complémentaire (/outcomp) du signal logique d'entrée non-contrôlé (outcomp) ;
le circuit de génération de signaux de commande (17) étant configuré pour commander le premier signal de génération (muxtx) et le second signal de génération (muxvh) de sorte que :
▪ le premier signal de génération (muxtx) est à l'état bas dans la phase de charge (E3) et à l'état haut dans les phases d'initialisation (E1) et de précharge (E2) de la période de comptage (Pc) ; et
▪ le second signal de génération (muxvh) est à l'état haut dans les phases d'initialisation (E1), de précharge (E2) et de charge (E3) de la période de comptage (Pc) ;
le premier signal de génération (muxtx) et le second signal de génération (muxvh) présentant une tension de réinitialisation (vmilieu) durant une période de réinitialisation (Pr) de sorte à amener le signal logique d'entrée (vdata) à la tension de réinitialisation (vmilieu) durant une période de réinitialisation (Pr).

8. Compteur analogique selon l'une des revendications 1 à 7, ***dans lequel*** le circuit de génération de signaux de commande (17) est configuré pour transmettre un signal d'horloge (/Φ) sur le transistor de transfert (Mt) dont l' amplitude est limitée de sorte que le transistor de transfert (Mt) n'est pas en régime ohmique dans les phases de précharge (E2) et de charge (E3).

9. Compteur analogique selon l'une des revendications 1 à 8, ***dans lequel*** le circuit de remise à zéro (18) est réalisé par un transistor (Mr) dont le drain est connecté à la tension (Vint) aux bornes de la capacité d'intégration (Cint), dont la source est connectée à une tension d'initialisation (Vinit) et dont la grille est commandée par un signal de remise à zéro (reset) généré par le circuit de génération de signaux de commande (17).

10. Compteur analogique selon l'une des revendications 1 à 9, ***dans lequel*** la capacité d'injection (Cinj) et la capacité d'intégration (Cint) sont réalisées par des capacités MOS de même technologie de réalisation CMOS.

## Patentansprüche

1. Analogzähler (10-12) der Anzahl von Ereignissen mindestens eines logischen Eingangssignals (vp, vn, vdata, outcomp) während eines Zählzeitraums (Pc), wobei der Zählzeitraum (Pc) eine Reihe von Erfassungszyklen (Cd) umfasst, während denen ein Ereignis des logischen Eingangssignals (vp, vn, vdata, outcomp) erfasst werden kann, wobei der Analogzähler (10-12) umfasst:
▪ eine Schaltung zur periodischen Erzeugung einer kalibrierten Menge von Ladungen (15) für jeden Erfassungszyklus (Cd);
▪ eine Integrationskapazität (Cint), die so konfiguriert ist, dass sie die kalibrierte Menge von Ladungen während jedes Erfassungszyklus (Cd) des Zählzeitraums (Pc) speichert, für den ein Ereignis des logischen Eingangssignals (vp, vn, vdata, outcomp) erfasst wird, so dass eine Ausgangsspannung (Vint) an den Anschlüssen der Integrationskapazität (Cint) für die Anzahl der während des Zählzeitraums (Pc) erfassten Ereignisse des logischen Eingangssignals (vp, vn, vdata, outcomp) repräsentativ ist;
▪ eine durch das logische Eingangssignal (vp, vn, vdata, outcomp) gesteuerte Weiterleitungsschaltung (16) für die kalibrierte Menge von Ladungen, um diese kalibrierte Menge von Ladungen nur dann in der Integrationskapazität (Cint) zu speichern, wenn ein Ereignis am logischen Eingangssignal (vp, vn, vdata, outcomp) erfasst wird;
▪ eine Schaltung zur Erzeugung von Steuersignalen (17) des Analogzählers (10-12); und
▪ eine Schaltung zum Zurücksetzen (18) der Ausgangsspannung (Vint) an den Anschlüssen der Integrationskapazität (Cint), um die Zählung zurückzusetzen;
die Schaltung zur periodischen Erzeugung einer kalibrierten Menge von Ladungen (15), umfassend:
▪ eine Injektionskapazität (Cinj), die so konfiguriert ist, dass sie bei jedem Erfassungszyklus (Cd) die kalibrierte Menge von Ladungen speichert, und die über einen ihrer Anschlüsse mit einer ersten Vorspannung (Vpol1) verbunden ist;
▪ einen Ladetransistor (Mc), dessen Source mit einer zweiten Vorspannung (Vpol2) verbunden ist und dessen Drain mit dem Injektionsknoten (N1) verbunden ist; und
▪ einen Übertragungstransistor (Mt), dessen Source mit dem Injektionsknoten (N1) verbunden ist und dessen Drain mit einem Weiterleitungsknoten (N2) verbunden ist;
**dadurch gekennzeichnet, dass**:
die Schaltung zur periodischen Erzeugung einer kalibrierten Menge von Ladungen (15) umfasst: einen Injektionssteuertransistor (Mct), dessen Source mit dem anderen Anschluss der Injektionskapazität (Cinj) verbunden ist, dessen Gate mit einer Steuerspannung (Vt) verbunden ist und dessen Drain mit einem Injektionsknoten (N1) verbunden ist;
wobei das Gate der beiden Lade- und Übertragungstransistoren (Mc, Mt) durch phasenentgegengesetzte Taktsignale (Φ,/Φ) gesteuert wird, um die Injektionskapazität (Cinj) zu laden und anschließend die in der Injektionskapazität (Cinj) gespeicherten Ladungen an die Weiterleitungsschaltung (16) zu übertragen;
wobei die Schaltung zur Erzeugung von Steuersignalen (17) so konfiguriert ist, dass sie die Steuerspannung (Vt) und die Taktsignale (Φ,/Φ) so steuert, dass bei jedem Erfassungszyklus (Cd) nacheinander die folgenden Phasen erzeugt werden:
▪ eine Initialisierungsphase (E1), in der der Injektionssteuertransistor (Mct) und der Ladetransistor (Mc) leitend sind, während der Übertragungstransistor (Mt) gesperrt ist;
▪ eine Vorladephase (E2), in der der Injektionssteuertransistor (Mct) und der Übertragungstransistor (Mt) leitend sind, während der Ladetransistor (Mc) gesperrt ist, wobei die Steuerspannung (Vt) auf einen ersten Wert (vtx1) festgelegt ist; und
▪ eine Ladephase (E3), in der der Injektionssteuertransistor (Mct) und der Übertragungstransistor (Mt) leitend sind, während der Ladetransistor (Mc) gesperrt ist, wobei die Steuerspannung (Vt) auf einen zweiten Wert (vtx2) festgelegt ist.

2. Analogzähler nach Anspruch 1, **bei dem** die Weiterleitungsschaltung (16) zwei Leitungen (L1, L2) umfasst:
▪ eine Leitung zum Ableiten der Ladungen (L1), die einen Ableitungstransistor (Md1) umfasst, dessen Source mit dem Weiterleitungsknoten (N2) verbunden ist und dessen Drain mit einer dritten Vorspannung (Vpol3) verbunden ist; und
▪ eine Leitung zum Übertragen von Ladungen (L2), die einen Zähltransistor (Md2) umfasst, dessen Source mit dem Weiterleitungsknoten (N2) verbunden ist und dessen Drain mit der Integrationskapazität (Cint) verbunden ist;
wobei das Gate der Transistoren (Md1, Md2) der beiden Leitungen (L1, L2) durch logische Eingangssignale (vp, vn, vdata, outcomp) gesteuert wird, die bestimmen, ob die in der Injektionskapazität (Cinj) gespeicherten Ladungen abgeleitet oder in die Integrationskapazität (Cint) übertragen werden.

3. Analogzähler nach Anspruch 2, **bei dem** der Injektionssteuertransistor (Mct), die beiden Übertragungstransistoren (Mc, Mt), der Ableitungstransistor (Md1) und der Zähltransistor (Md2) aus NMOS-Transistoren gebildet sind, wobei die erste Vorspannung (Vpol1) und die zweite Vorspannung (Vpol2) niedrigen Spannungspegeln entsprechen, während die dritte Vorspannung (Vpol3) einem hohen Spannungspegel entspricht.

4. Analogzähler nach Anspruch 2, **bei dem** der Injektionssteuertransistor (Mct), die beiden Übertragungstransistoren (Mc, Mt), der Ableitungstransistor (Md1) und der Zähltransistor (Md2) aus PMOS-Transistoren gebildet sind, wobei die erste Vorspannung (Vpol1) und die zweite Vorspannung (Vpol2) hohen Spannungspegeln entsprechen, während die dritte Vorspannung (Vpol3) einem niedrigen Spannungspegel entspricht.

5. Analogzähler nach einem der Ansprüche 2 bis 4, **bei dem** der Ableitungstransistor (Md1) der Leitung zum Ableiten der Ladungen (L1) durch ein variables logisches Eingangssignal (vp) gesteuert wird, während der Zähltransistor (Md2) der Leitung zum Übertragen der Ladungen (L2) durch ein festes Signal (vn) gesteuert wird, so dass eine Aktivierung des variablen logischen Eingangssignals (vp) in der Ladephase (E3) zu einer Übertragung der kalibrierten Ladungen in die Integrationskapazität (Cint) führt.

6. Analogzähler nach Anspruch 5, **bei dem** die Leitung zum Ableiten der Ladungen (L1) außerdem umfasst:
▪ eine Offset-Kapazität (Caz), die zwischen einem gesteuerten logischen Eingangssignal (vdata) und dem Gate des Ableitungstransistors (Md1) angeschlossen ist, sodass das variable logische Eingangssignal (vp) aus dem gesteuerten logischen Eingangssignal (vdata) durch Anlegen eines durch die Spannung der Offset-Kapazität (Caz) erzeugten Offsets gewonnen wird;
▪ einen ersten Offset-Transistor (Mo1), der zwischen dem Drain des Ableitungstransistors (Md1) und der dritten Vorspannung (Vpol3) angeschlossen ist, wobei die Source des ersten Offset-Transistors (Mo1) mit der dritten Vorspannung (Vpol3) verbunden ist, sein Drain mit dem Drain des Ableitungstransistors (Md1) verbunden ist und sein Gate durch ein erstes Offset-Signal (setvp) gesteuert wird, das von der Schaltung zur Erzeugung von Steuersignalen (17) erzeugt wird; und
▪ einen zweiten Offset-Transistor (Mo2), der zwischen Drain und Gate des Ableitungstransistors (Md1) angeschlossen ist, wobei der Drain des zweiten Offset-Transistors (Mo2) mit dem Drain des Ableitungstransistors (Md1) verbunden ist, seine Source mit dem Gate des Ableitungstransistors (Md1) verbunden ist und sein Gate durch ein zweites Offset-Signal (resetvp) gesteuert wird, das von der Schaltung zur Erzeugung von Steuersignalen (17) erzeugt wird;
wobei die Schaltung zur Erzeugung von Steuersignalen (17) so konfiguriert ist, dass sie das erste Offset-Signal (setvp) und das zweite Offset-Signal (resetvp) so steuert, dass innerhalb eines Rücksetzzeitraums (Pr) nacheinander die folgenden Vorgänge erzeugt werden:
▪ ein Ladevorgang (P1) der Offset-Kapazität (Caz), bei dem der erste Offset-Transistor (Mo1) leitend ist und der zweite Offset-Transistor (Mo2) leitend ist;
▪ ein Entladevorgang (P2) der Offset-Kapazität (Caz), bei dem der erste Offset-Transistor (Mo1) gesperrt und der zweite Offset-Transistor (Mo2) leitend ist, wobei dieser Entladevorgang (P2) über eine bestimmte Anzahl von Kalibrierungszyklen (Cc) aufrechterhalten wird, während denen die Phasen der Initialisierung (E1), der Vorladung (E2) und der Ladung (E3) durchgeführt werden; und
▪ ein Abtastvorgang (P3) der Offset-Kapazität (Caz), bei dem der erste Offset-Transistor (Mo1) gesperrt ist und der zweite Offset-Transistor (Mo2) gesperrt ist;
wobei das gesteuerte logische Eingangssignal (vdata) während der Lade- (P1), Entlade- (P2) und Abtastvorgänge (P3) auf einen Rücksetzspannungswert (vmilieu) festgelegt ist;
wobei die Schaltung zur Erzeugung von Steuersignalen (17) so konfiguriert ist, dass sie das erste Offset-Signal (setvp) und das zweite Offset-Signal (resetvp) so steuert, dass während des Zählzeitraums (Pc) der erste Offset-Transistor (Mo1) leitend und der zweite Offset-Transistor (Mo2) gesperrt ist.

7. Analogzähler nach einem der Ansprüche 2 bis 6, **bei dem** die Leitung zum Ableiten der Ladungen (L1) außerdem eine Schaltung zur Erzeugung des variablen logischen Eingangssignals (19) umfasst, wobei diese umfasst:
▪ einen ersten Erzeugungstransistor (M1), dessen erster Anschluss, Source oder Drain, mit einem ersten Erzeugungssignal (muxtx) verbunden ist, dessen zweiter Anschluss, Source oder Drain, mit dem logischen Eingangssignal (vp, vdata) verbunden ist und dessen Gate mit einem nicht gesteuerten logischen Eingangssignal (outcomp) verbunden ist; und
▪ einen zweiten Erzeugungstransistor (M2), dessen erster Anschluss, Source oder Drain, mit einem zweiten Erzeugungssignal (muxvh) verbunden ist, dessen zweiter Anschluss, Source oder Drain, mit dem gesteuerten logischen Eingangssignal (vp, vdata) verbunden ist und dessen Gate mit einem komplementären Signal (/outcomp) des nicht gesteuerten logischen Eingangssignals (outcomp) verbunden ist;
wobei die Schaltung zur Erzeugung von Steuersignalen (17) so konfiguriert ist, dass sie das erste Erzeugungssignal (muxtx) und das zweite Erzeugungssignal (muxvh) so steuert, dass:
▪ das erste Erzeugungssignal (muxtx) in der Ladephase (E3) im Low-Zustand und in der Initialisierungsphase (E1) und der Vorladephase (E2) des Zählzeitraums (Pc) im High-Zustand ist; und
▪ das zweite Erzeugungssignal (muxvh) in der Initialisierungsphase (E1), der Vorladephase (E2) und der Ladephase (E3) des Zählzeitraums (Pc) im High-Zustand ist;
wobei das erste Erzeugungssignal (muxtx) und das zweite Erzeugungssignal (muxvh) während eines Rücksetzzeitraums (Pr) eine Rücksetzspannung (vmilieu) aufweisen, um das logische Eingangssignal (vdata) während eines Rücksetzzeitraums (Pr) auf die Rücksetzspannung (vmilieu) zu bringen.

8. Analogzähler nach einem der Ansprüche 1 bis 7, **bei dem** die Schaltung zur Erzeugung von Steuersignalen (17) so konfiguriert ist, dass sie ein Taktsignal (/Φ) an den Übertragungstransistor (Mt) übermittelt, dessen Amplitude so begrenzt ist, dass sich der Übertragungstransistor (Mt) in der Vorladephase (E2) und der Ladephase (E3) außerhalb des ohmschen Betriebsbereichs befindet.

9. Analogzähler nach einem der Ansprüche 1 bis 8, **bei dem** die Schaltung zum Zurücksetzen (18) durch einen Transistor (Mr) gebildet wird, dessen Drain mit der Spannung (Vint) über die Anschlüsse der Integrationskapazität (Cint) verbunden ist, dessen Source mit einer Initialisierungsspannung (Vinit) verbunden ist und dessen Gate durch ein von der Schaltung zur Erzeugung von Steuersignalen (17) erzeugtes Rücksetzsignal (reset) gesteuert wird.

10. Analogzähler nach einem der Ansprüche 1 bis 9, **bei dem** die Injektionskapazität (Cinj) und die Integrationskapazität (Cint) durch MOS-Kapazitäten derselben CMOS-Fertigungstechnologie realisiert sind.

## Claims

1. Analog counter (10-12) of the number of events in at least one logic input signal (vp, vn, vdata, outcomp) over a counting period (Pc), said counting period (Pc) comprising a set of detection cycles (Cd) during which an event in the logic input signal (vp, vn, vdata, outcomp) can be detected, comprising:
▪ a circuit for periodically generating a calibrated quantity of charge (15) for each detection cycle (Cd);
▪ an integration capacitor (Cint) configured to store said calibrated quantity of charge during each detection cycle (Cd) of the counting period (Pc) for which an event in the logic input signal (vp, vn, vdata, outcomp) is detected so that an output voltage (Vint), across the integration capacitor (Cint), is representative of the number of events of the logic input signal (vp, vn, vdata, outcomp) detected during the counting period (Pc);
▪ a circuit (16) for switching the calibrated quantity of charge controlled by the logic input signal (vp, vn, vdata, outcomp) to store said calibrated quantity of charge into the integration capacitor (Cint) only when an event is detected on the logic input signal (vp, vn, vdata, outcomp);
▪ a circuit for generating control signals (17) of the analog counter (10-12); et
▪ a circuit (18) for resetting the output voltage (Vint) across the integration capacitor (Cint) so as to reset the counting;
the circuit for periodically generating a calibrated quantity of charge (15) comprising:
▪ an injection capacitor (Cinj) configured to store the calibrated quantity of charge during each detection cycle (Cd) and connected by one of its terminals to a first bias voltage (Vpol1);
▪ a charge transistor (Mc) having its source connected to a second bias voltage (Vpol2) and having its drain connected to the injection node (N1); and
▪ a transfer transistor (Mt) having its source connected to the injection node (N1) and having its drain connected to a switching node (N2);
***characterized in that :***
the circuit for periodically generating a calibrated quantity of charge (15) comprises an injection control transistor (Mct) having its source connected to the other terminal of the injection capacitor (Cinj), having its gate connected to a control voltage (Vt), and having its drain connected to an injection node (N1);
the gate of the two charge and transfer transistors (Mc, Mt) being controlled by clock signals (Φ, /Φ) in phase opposition so as to charge said injection capacitor (Cinj), and then to transfer the charges accumulated in said injection capacitor (Cinj) to the switching circuit (16);
the control signal generation circuit (17) being configured to control the control voltage (Vt) and the clock signals (Φ, /Φ) so as to successively generate the following phases at each detection cycle (Cd):
▪ an initialization phase (E1) during which the injection control transistor (Mct) and the charge transistor (Mc) are on while the transfer transistor (Mt) is off;
▪ a precharge phase (E2) during which the injection control transistor (Mct) and the transfer transistor (Mt) are on while the charge transistor (Mc) is off, the control voltage (Vt) being set to a first value (vtx1); and
▪ a charge phase (E3) during which the injection control transistor (Mct) and the transfer transistor (Mt) are on while the charge transistor (Mc) is off, the control voltage (Vt) being set to a second value (vtx2).

2. The analog counter according to claim 1, ***wherein*** the switching circuit (16) comprises two lines (L1, L2):
▪ a charge evacuation line (L1) comprising an evacuation transistor (Md1) having its source connected to the switching node (N2) and having its drain connected to a third bias voltage (Vpol3); and
▪ a charge transfer line (L2) comprising a counting transistor (Md2) having its source connected to said switching node (N2) and having its drain connected to the integration capacitor (Cint);
the gate of the transistors (Md1, Md2) of the two lines (L1, L2) being controlled by logic input signals (vp, vn, vdata, outcomp) which determine whether the charges stored in the injection capacitor (Cinj) are evacuated or transferred into the integration capacitor (Cint).

3. The analog counter according to claim 2, ***wherein*** the injection control transistor (Mct), the two transfer transistors (Mc, Mt), the evacuation transistor (Md1), and the counting transistor (Md2) are formed of transistors NMOS, the first bias voltage (Vpol1) and the second bias voltage (Vpol2) corresponding to low voltage levels while the third bias voltage (Vpol3) corresponds to a high voltage level.

4. The analog counter according to claim 2, ***wherein*** the injection control transistor (Mct), the two transfer transistors (Mc, Mt), the evacuation transistor (Md1), and the counting transistor (Md2) are formed of transistors PMOS, the first bias voltage (Vpol1) and the second bias voltage (Vpol2) corresponding to high voltage levels while the third bias voltage (Vpol3) corresponds to a low voltage level.

5. The analog counter according to any of claims 2 to 4, ***wherein*** the evacuation transistor (Md1) of the charge evacuation line (L1) is controlled by a variable logic input signal (vp), while the counting transistor (Md2) of the charge transfer line (L2) is controlled by a fixed signal (vn), so that an activation of the variable logic input signal (vp) in the charge phase (E3) causes a transfer of the calibrated charges into the integration capacitor (Cint).

6. The analog counter according to claim 5, ***wherein*** the charge evacuation line (L1) also comprises:
▪ an offset capacitor (Caz) connected between a controlled logic input signal (vdata) and the gate of the evacuation transistor (Md1) so that the variable logic input signal (vp) is obtained from the controlled logic input signal (vdata) by applying an offset generated by the voltage of the offset capacitor (Caz);
▪ a first offset transistor (Mo1) assembled between the drain of the evacuation transistor (Md1) and the third bias voltage (Vpol3), the source of the first offset transistor (Mo1) being connected to the third bias voltage (Vpol3), its drain being connected to the drain of the evacuation transistor (Md1), and its gate being controlled by a first offset signal (setvp) generated by the control signal generation circuit (17); and
▪ a second offset transistor (Mo2) assembled between the drain and the gate of the evacuation transistor (Md1), the drain of the second offset transistor (Mo2) being connected to the drain of the evacuation transistor (Md1), its source being connected to the gate of the evacuation transistor (Md1), and its gate being controlled by a second offset signal (resetvp) generated by the control signal generation circuit (17);
the control signal generation circuit (17) being configured to control the first offset signal (setvp) and the second offset signal (resetvp) so as to successively generate the following episodes in a reset period (Pr):
▪ a charge episode (P1) of the offset capacitor (Caz) during which the first offset transistor (Mo1) is on and the second offset transistor (Mo2) is on;
▪ a discharge episode (P2) of the offset capacitor (Caz) during which the first offset transistor (Mo1) is off and the second offset transistor (Mo2) is on, this discharge episode (P2) being maintained for a number of calibration cycles (Cc) during which the phases of initialization (E1), precharge (E2), and charge (E3) are implemented; and
▪ a sampling episode (P3) of the offset capacitor (Caz) during which the first offset transistor (Mo1) is off and the second offset transistor (Mo2) is off;
the controlled logic input signal (vdata) being set to a reset voltage value (vmiddle) during the charge (P1), discharge (P2) and sampling (P3) episodes;
the control signal generation circuit (17) being configured to control the first offset signal (setvp) and the second offset signal (resetvp) so that the first offset transistor (Mo1) is on and the second offset transistor (Mo2) is off during the counting period (Pc).

7. The analog counter according to any of claims 2 to 6, ***wherein*** the charge evacuation line (L1) also comprises circuit for generating the variable logic input signal (19), the latter comprising:
▪ a first generation transistor (M1) having a first terminal, source or drain, connected to a first generation signal (muxtx), a second terminal, source or drain, connected to the logic input signal (vp, vdata), and its gate connected to a non-controlled logic input signal (outcomp); and
▪ a second generation transistor (M2) having a first terminal, source or drain, connected to a second generation signal (muxvh), a second terminal, source or drain, connected to the controlled logic input signal (vp, vdata), and its gate connected to a signal (/outcomp) complementary to the non-controlled logic input signal (outcomp);
the control signal generation circuit (17) being configured to control the first generation signal (muxtx) and the second generation signal (muxvh) so that:
▪ the first generation signal (muxtx) is in the low state during the charge phase (E3) and in the high state during the initialization (E1) and precharge (E2) phases of the counting period (Pc); and
▪ the second generation signal (muxvh) is in the high state during the initialization (E1), precharge (E2), and charge (E3) phases of the counting period (Pc);
the first generation signal (muxtx) and the second generation signal (muxvh) having a reset voltage (vmiddle) during a reset period (Pr) so as to bring the logic input signal (vdata) to the reset voltage (vmiddle) during a reset period (Pr).

8. The analog counter according to any of claims 1 to 7, ***wherein*** the control signal generation circuit (17) is configured to transmit a clock signal (/Φ) to the transfer transistor (Mt) having a limited amplitude so that the transfer transistor (Mt) is not in ohmic mode during the precharge (E2) and charge (E3) phases.

9. The analog counter according to any of claims 1 to 8, ***wherein*** the reset circuit (18) is formed by a transistor (Mr) having its drain connected to the voltage (Vint) across the integration capacitor (Cint), having its source is connected to an initialization voltage (Vinit), and having its gate controlled by a reset signal (reset) generated by the control signal generation circuit (17).

10. The analog counter according to any of claims 1 to 9, ***wherein*** the injection capacitor (Cinj) and the integration capacitor (Cint) are formed by MOS capacitors of same CMOS manufacturing technology.
